# EUROPEAN PATENT APPLICATION

(11) **EP 4 773 761 A1**
(43) Date of publication of application: **08.07.2026**
(21) Application number: 24870705.1
(22) Date of filing: 24.09.2024
(51) Int. Cl.: H10F 77/1223, H10F 71/00, H10F 19/90

(54) **MIXED DOPED SILICON WAFER**

(30) Priority: 27.09.2023 CN 202311270281
(71) Applicant: Longi Green Energy Technology Co., Ltd., Xi'an, Shaanxi 710100 (CN)
(72) Inventor: DOU, Maofeng, Xi' an, Shaanxi 710100 (CN); WU, Zhao, Xi' an, Shaanxi 710100 (CN); WANG, Jing, Xi' an, Shaanxi 710100 (CN)
(74) Representative: Pfenning, Meinig & Partner mbB
(86) International application number: PCT/CN2024/120741
(87) International publication number: WO 2025/067161

(57) **Abstract**

The present application relates to a silicon wafer. The silicon wafer includes antimony and carbon. A ratio of a doping concentration of antimony to a doping concentration of carbon ranges from 1:0.1 to 1:12.5.

## Description

### TECHNICAL FIELD

The present application belongs to the technical field of czochralski silicon, and relates to a co-doped silicon wafer, a preparation method of a co-doped silicon wafer, as well as a solar cell and a solar cell module including the silicon wafer.

### BACKGROUND

With the increasing exhaustion of conventional energy sources and increasing requirements of people for the environment, as a pollution-free clean energy source, solar cells develop more rapidly. However, a preparation technology of crystalline silicon solar cells that nowadays occupy most of the market of solar cells represents the level of the entire solar cell industry.

A working principle of a solar cell is: When sunlight is shed on the solar cell, the solar cell absorbs the optical energy, to generate photogenerated electron-hole pairs. Under the action of a built-in electric field of the solar cell, photogenerated electrons and holes are separated, and charges of different signs are accumulated at two ends of a photovoltaic cell. To be specific, a "photogenerated voltage" is generated, which is a "photogenerated volt effect". If electrodes are led out and a load is connected on two sides of the built-in electric field, a "photogenerated current" flows in the load, thereby obtaining power output. In this way, the optical energy of the sun directly becomes practical electric energy.

The most important performance of the solar cell is photoelectric conversion efficiency, and there is a close relationship between the length of the minority carrier lifetime of the silicon wafer and the conversion efficiency. To achieve higher photoelectric conversion efficiency, a silicon wafer having a higher minority carrier lifetime is needed.

### SUMMARY

The inventor of the present application has developed a silicon wafer doped with antimony as a main Group-V doping element, which exhibits excellent performance. The inventor of the present application has found that further co-doping antimony with other elements can broaden the distribution of a minority carrier lifetime of the silicon wafer and render the minority carrier lifetime more stable. Given that the minority carrier lifetime is highly susceptible to variations in solar cell processes, there is an urgent need in the art to further develop a co-doped silicon wafer to resolve the foregoing problems.

The applicant of the present application has intensively researched to obtain a silicon wafer having a minority carrier lifetime significantly longer than that of the silicon wafer in the related art. Specifically, the present application relates to the following content:
1. A silicon wafer, including antimony and carbon, where a ratio of a doping concentration of antimony to a doping concentration of carbon ranges from 1:0.1 to 1:12.5.
2. The silicon wafer according to clause 1, where the doping concentration of carbon ranges from 4E+13 cm⁻³ to 2.5E+17 cm⁻³
3. The silicon wafer according to clause 1 or 2, where the doping concentration of antimony ranges from 4E+14 cm⁻³ to 2E+16 cm⁻³, preferably from 4.3E+14 cm⁻³ to 1.9E+16 cm⁻³, and further preferably from 4.45E+14 cm⁻³ to 1.87E+16 cm⁻³.
4. The silicon wafer according to any one of clauses 1 to 3, where when the doping concentration of antimony is greater than or equal to 4E+14 cm⁻³ and less than or equal to a, the ratio of the doping concentration of antimony to the doping concentration of carbon ranges from 1:b to 1:12.5, a being selected from the range of 8E+15 cm⁻³ to 1.2E+16 cm⁻³, preferably from 9E+15 cm⁻³ to 1.1E+16 cm⁻³, and further preferably being 1E+16 cm⁻³, and b being greater than 0.1, preferably greater than 0.5, and further preferably greater than 0.7.
5. The silicon wafer according to any one of clauses 1 to 3, where when the doping concentration of antimony is greater than or equal to a and less than or equal to 2E+16 cm⁻³, the ratio of the doping concentration of antimony to the doping concentration of carbon ranges from 1:0.1 to 1:c, a being selected from the range of 8E+15 cm⁻³ to 1.2E+16 cm⁻³, preferably from 9E+15 cm⁻³ to 1.1E+16 cm⁻³, and further preferably being 1E+16 cm⁻³, and c being less than 0.8, preferably less than 0.5, and further preferably less than 0.3.
6. The silicon wafer according to any one of clauses 1 to 5, where the silicon wafer has a resistivity of 0.3 Ω·cm to 10 Ω·cm, preferably 0.4 Ω·cm to 8 Ω·cm, and further preferably 0.5 Ω·cm to 6 Ω·cm.
7. The silicon wafer according to any one of clauses 1 to 6, where a minority carrier lifetime of the silicon wafer is greater than or equal to 200 microseconds, preferably greater than or equal to 300 microseconds, and further preferably greater than or equal to 500 microseconds.
8. The silicon wafer according to any one of clauses 1 to 7, where a resistivity variation rate of the silicon wafer is less than or equal to 0.6, preferably less than or equal to 0.5, and more preferably less than or equal to 0.4.
9. The silicon wafer according to any one of clauses 1 to 8, where a total oxygen content in the silicon wafer is less than 25 ppma, preferably less than 18 ppma, and further preferably less than 14 ppma; or
   the total oxygen content in the silicon wafer is greater than 2 ppma, preferably greater than 3 ppma, and further preferably greater than 4 ppma.
10. The silicon wafer according to any one of clauses 1 to 9, further including at least one of phosphorus, gallium, or germanium.
11. The silicon wafer according to any one of clauses 1 to 10, where a mechanical strength of the silicon wafer is greater than or equal to 70 MPa, and/or a dispersion degree of the mechanical strength of the silicon wafer is less than or equal to 0.9.
12. The silicon wafer according to any one of clauses 1 to 11, where a length of at least one side of the silicon wafer is greater than or equal to 156 mm.
13. The silicon wafer according to any one of clauses 1 to 12, where the silicon wafer is a rectangle, one side of the rectangle having a length of 156 mm to 300 mm, and the other side having a length of 83 mm to 300 mm.
14. The silicon wafer according to any one of clauses 1 to 13, further including a chamfer connected between two adjacent sides of the silicon wafer, where a projection length of an arc length of the chamfer ranges from 1 mm to 10 mm.
15. The silicon wafer according to any one of clauses 1 to 14, where a thickness of the silicon wafer ranges from 40 µm to 170 µm, preferably 70 µm to 160 µm, and further preferably 80 µm to 140 µm.
16. A solar cell, including the silicon wafer according to any one of clauses 1 to 15.
17. The solar cell according to clause 16, where a mechanical strength of the solar cell is greater than or equal to 50 MPa, preferably greater than or equal to 60 Mpa, and more preferably greater than or equal to 70 Mpa.
18. The solar cell according to clause 16 or 17, where a thickness of the solar cell ranges from 40 µm to 170 µm, preferably 70 µm to 160 µm, and further preferably 80 µm to 140 µm.
19. The solar cell according to any one of clauses 16 to 18, where one side of the solar cell has a margin of 156 mm to 300 mm, and the other side of the solar cell has a margin of 83 mm to 300 mm.
20. A solar cell, including a silicon substrate, where the silicon substrate includes a silicon matrix and a doped region inside a surface of at least one side of the silicon substrate, the silicon substrate contains antimony and carbon, the doped region is doped with a doping element, the doping element is selected from Group-IIIA elements or Group-VA elements, and a ratio of a doping concentration of antimony to a doping concentration of carbon ranges from 1:0.1 to 1:12.5.
21. The solar cell according to clause 20, where the doping concentration of carbon in the silicon substrate ranges from 4E+13 cm⁻³ to 2.5E+17 cm⁻³.
22. The solar cell according to clause 20 or 21, where the doping concentration of antimony in the silicon substrate ranges from 4E+14 cm⁻³ to 2E+16 cm⁻³, preferably from 4.3E+14 cm⁻³ to 1.9E+16 cm⁻³, and further preferably from 4.45E+14 cm⁻³ to 1.87E+16 cm⁻³.
23. The solar cell according to any one of clauses 20 to 22, where when the doping concentration of antimony is greater than or equal to 4E+14 cm⁻³ and less than or equal to a, the ratio of the doping concentration of antimony to the doping concentration of carbon ranges from 1:b to 1:12.5, a being selected from the range of 8E+15 cm⁻³ to 1.2E+16 cm⁻³, preferably from 9E+15 cm⁻³ to 1.1E+16 cm⁻³, and further preferably being 1E+16 cm⁻³, and b being greater than 0.1, preferably greater than 0.5, and further preferably greater than 0.7.
24. The solar cell according to any one of clauses 20 to 23, where when the doping concentration of antimony is greater than or equal to a and less than or equal to 2E+16 cm⁻³, the ratio of the doping concentration of antimony to the doping concentration of carbon ranges from 1:0.1 to 1:c, a being selected from the range of 8E+15 cm⁻³ to 1.2E+16 cm⁻³, preferably from 9E+15 cm⁻³ to 1.1E+16 cm⁻³, and further preferably being 1E+16 cm⁻³, and c being less than 0.8, preferably less than 0.5, and further preferably less than 0.3.
25. The solar cell according to any one of clauses 20 to 24, where the silicon substrate has a resistivity of 0.3 Ω·cm to 10 Ω·cm, preferably 0.4 Ω·cm to 8 Ω·cm, and further preferably 0.5 Ω·cm to 6 Ω·cm.
26. The solar cell according to any one of clauses 20 to 25, where a minority carrier lifetime of the silicon substrate is greater than or equal to 200 microseconds, preferably greater than or equal to 300 microseconds, and further preferably greater than or equal to 500 microseconds.
27. The solar cell according to any one of clauses 20 to 26, where a resistivity variation rate of the silicon substrate is less than or equal to 0.6, preferably less than or equal to 0.5, and more preferably less than or equal to 0.4.
28. The solar cell according to any one of clauses 20 to 27, where a total oxygen content in the silicon substrate is less than 25 ppma, preferably less than 18 ppma, and further preferably less than 14 ppma; or the total oxygen content in the silicon substrate is greater than 2 ppma, preferably greater than 3 ppma, and further preferably greater than 4 ppma.
29. The solar cell according to any one of clauses 20 to 28, where the silicon matrix further includes at least one of phosphorus, gallium, or germanium.
30. The solar cell according to any one of clauses 20 to 29, where at least one doped layer is provided on a surface of at least one side of the silicon substrate.
31. The solar cell according to clause 30, where at least one passivation layer is provided between the doped layer and the doped region.
32. The solar cell according to any one of clauses 20 to 31, where the doping concentration of antimony in the doped region is substantially constant in a thickness direction of the silicon substrate.
33. The solar cell according to any one of clauses 20 to 32, where
   in the doped region, a sum of the doping concentration of antimony and a doping concentration of the doping element is less than or equal to 1E+21 cm⁻³.
34. The solar cell according to any one of clauses 20 to 33, further including:
   a light absorbing body, the light absorbing body including the silicon substrate for absorbing light and generating photogenerated carriers and a region for separating the carriers generated by the silicon substrate; and
   an electrode formed on the light absorbing body, the electrode including a metallic crystal part in contact with the light absorbing body, and the metallic crystal part including antimony.
35. The solar cell according to any one of clauses 20 to 34, where a mechanical strength of the solar cell is 50 MPa, preferably greater than or equal to 60 Mpa, and more preferably greater than or equal to 70 Mpa.
36. A solar cell string, including solar cells connected to each other by using a conductive interconnection member, where at least one of the solar cells is the solar cell according to any one of clauses 16 to 35.
37. The solar cell string according to clause 36, where a curvature of the solar cell is less than or equal to 2 mm.
38. The solar cell string according to clause 36 or 37, where the connection wire is bonded to the solar cell by soldering or conductive adhesion.
39. The solar cell string according to clause 38, where the soldering includes a heating step.
40. The solar cell string according to clause 39, where a temperature interval of the heating step ranges from 100 to 160 degrees Celsius, and the curvature of the solar cell is less than or equal to 1.5 mm.
41. The solar cell string according to clause 39, where a temperature interval of the heating step ranges from 165 to 200 degrees Celsius, and the curvature of the solar cell is less than or equal to 2 mm.
42. The solar cell string according to any one of clauses 36 to 41, where the conductive interconnection member includes an electric contact part in contact with an electrode of the solar cell, and the electric contact part includes antimony.
43. A solar module, including a plurality of solar cells, an encapsulation layer, a cover, and a back sheet, where the plurality of solar cells are sealed in the encapsulation layer, the sealing layer is located between the cover and the back sheet, and the solar cell is the solar cell according to any one of clauses 16 to 35.
44. The solar module according to clause 43, where a curvature of the solar cell is less than or equal to 1.2 mm.
45. The solar module according to clause 43 or 44, further including a frame, where an edge of the cover and/or the back sheet is embedded in a mounting part of the frame.
46. The solar module according to any one of clauses 43 to 45, where the cover and/or the back sheet is transparent.
47. The solar module according to any one of clauses 43 to 45, where the cover and/or the back sheet is non-transparent.
48. The solar module according to clauses 43 to 47, where the solar cell protrudes toward the cover to form a curved shape.
49. The solar module according to any one of clauses 43 to 48, where the plurality of solar cells are connected to each other by using a conductive interconnection member, the conductive interconnection member includes an electric contact part in contact with an electrode of the solar cell, and the electric contact part includes antimony.

### Effects

Through in-depth research, the applicant of the present application has found that doping antimony into a silicon wafer can significantly improve the resistivity. By designing appropriately co-doped silicon wafers, it has been found that the minority carrier lifetime after antimony doping can be further prolonged, and the uniformity of the minority carrier lifetime can be further improved remarkably.

By adopting a Sb-C co-doping scheme of the present application, the entire minority carrier lifetime and the distribution uniformity of the minority carrier lifetime can both be improved.

Solar cells prepared using the silicon wafer of the present application can exhibit excellent solar cell efficiency.

### BRIEF DESCRIPTION OF THE DRAWINGS

FIG. 1 is a schematic diagram of a solar cell structure (a TOPcon structure) according to the present application.
FIG. 2 is a schematic diagram of a solar cell stringing procedure.
FIG. 3 is another schematic diagram of a solar cell stringing procedure.
FIG. 4 is a specific schematic structural diagram of a solar cell module.
FIG. 5 is another specific schematic structural diagram of a solar cell module.
FIG. 6 shows a manner of testing a resistivity variation rate of a silicon wafer.

### DETAILED DESCRIPTION

The following embodiments of the present application are merely used for describing specific embodiments for implementing the present application, and these embodiments should not be construed as a limitation to the present application. Any alternation, modification, substitution, combination, and simplification without departing from the spiritual essence and principles of the present application are all considered as equivalent replacements, and all fall within the scope of protection of the present application.

Specific embodiments of the present application are described in more detail below. However, it should be understood that, the present application can be implemented in various manners and should not be limited by the embodiments described herein. On the contrary, the embodiments are provided, so that the present application can be understood more thoroughly and a scope of the present application can be completely conveyed to a person skilled in the art.

It should be noted that, some terms are used in this specification and the claims to refer to particular components. A person skilled in the art should understand that, the person skilled in the art may refer to a same component by using different terms. In this specification and the claims, a difference of terms is not used as a manner of distinguishing between components, but a difference of functions of the components is used as a criterion for distinguishing. For example, "comprise" or "include" throughout this specification and the claims is an open term, and therefore, should be interpreted as "include but not limited to". The subsequent description of this specification is preferred implementations of the present application, but the description is provided for describing general principle of this specification and is not intended to limit a scope of the present application. The protection scope of the present application shall be subject to a scope defined by the appended claims.

As used herein, "substantially not include" with respect to a specified component is used in this specification to represent that the specified component is not deliberately formulated into a compound and/or exists only as a pollutant or in trace amount. Therefore, a total amount of a specified component caused by any accidental pollution of the compound is less than 0.05%, and preferably less than 0.0 1%. Most preferably, the amount of the specified component in the compound cannot be detected by using a standard analysis method.

As used in this specification, "a" or "an" may indicate one or more. As used in the claims, when used together with the term "comprise", the terms "a" or "an" may indicate one or more than one.

The term "or" used in the claims is used to represent "and/or", unless it is explicitly indicated that only an alternative solution is referred to, or that alternative solutions are mutually exclusive, although the present disclosure supports a definition of referring to only an alternative solution and a definition of "and/or". As used herein, "another" may indicate at least a second or more.

A person skilled in the art may understand that a silicon wafer usually refers to a bare silicon wafer as a raw material, and a silicon substrate usually refers to a part formed by a silicon wafer in a solar cell. A light absorbing body generally refers to a functional body in a solar cell for absorbing photons, generating photogenerated carriers, and separating the photogenerated carriers. The light absorbing body includes a silicon substrate and a region (e.g., a tunneling layer and a doped polycrystalline layer in a TOPcon structure) for separating carriers generated by the silicon substrate. The silicon substrate is configured to absorb light and generate photogenerated carriers. It may be understood that a pure emission reduction layer, another functional layer, and an electrode do not belong to the light absorbing body. A person skilled in the art may understand that the light absorbing body or the silicon substrate may be recovered from the solar cell, and the silicon substrate defined in the present application may be obtained by striping different stack structures. In the present application, a doping concentration of antimony in the silicon wafer or the silicon substrate may be detected by using any method known by a person skilled in the art, and may be selected by the person skilled in the art based on a requirement. For example, the doping concentration may be detected by using a method such as SIMS, ICP-MS, or GDMS, and preferably detected by using an ICP-MS method. A person skilled in the art may understand that the doping concentration of antimony in the silicon wafer or the silicon substrate may refer to a doping concentration of antimony at any site on the surface of the silicon wafer or the silicon substrate, in the silicon wafer or the silicon substrate, or in the middle of the silicon wafer or the silicon substrate, and certainly, may alternatively be an average value of doping concentrations of antimony at a plurality of positions (e.g., concentrations at positions such as a midpoint and an edge) or an average value of doping concentrations of antimony on the entire silicon wafer or silicon substrate. A person skilled in the art may select any of the foregoing sites for detection based on a detection condition and a used instrument based on an actual situation, or may calculate an average value of a plurality of sites after detecting the plurality of sites and use the average value as the doping concentration of antimony.

In the present application, a doping concentration of carbon in the silicon wafer or the silicon substrate may be detected by using any method known by a person skilled in the art, and these methods may be selected by the person skilled in the art based on a requirement. For example, the doping concentration may be detected by using a method such as SIMS, ICP-MS, or GDMS, and preferably detected by using an ICP-MS method. A person skilled in the art may understand that the doping concentration of carbon in the silicon wafer or the silicon substrate may refer to a doping concentration of carbon at any site on the surface of the silicon wafer or the silicon substrate or in the middle of the silicon wafer or the silicon substrate, and certainly, may alternatively be an average value of doping concentrations of carbon at a plurality of positions (e.g., concentrations at positions such as a midpoint and an edge) or an average value of doping concentrations of carbon on the entire silicon wafer or silicon substrate. A person skilled in the art may select any of the foregoing sites for detection based on a detection condition and a used instrument based on an actual situation, or may calculate an average value of a plurality of sites after detecting the plurality of sites and use the average value as the doping concentration of carbon.

In the present application, the minority carrier lifetime of the silicon wafer or the silicon substrate may be detected by using any method known by a person skilled in the art, for example, may be detected by using a BCT-400 instrument, a WCT-120 instrument, or a WT-2000 instrument. During detection, a carrier injection level needs to be set to 1E+15 cm⁻³ to 3E+15 cm⁻³, and a minority carrier lifetime at the injection level is measured. However, a person skilled in the art can completely understand that the injection levels (1E+15 cm⁻³ to 3E+15 cm⁻³) listed above are merely a set range, and if the injection levels are set to another range, the injection levels may be converted.

A specific conversion method may be, for example, the following method: first, setting a carrier injection level to perform a minority carrier lifetime test, to obtain an injection level-minority carrier lifetime curve in which a horizontal coordinate is the injection level and a vertical coordinate is the minority carrier lifetime. By using the curve, a minority carrier lifetime in another carrier injection condition (e.g., a carrier injection level such as 5E+14 cm⁻³ is used) may be converted into a minority carrier lifetime at a carrier injection level of 1E+15 cm⁻³ to 3E+15 cm⁻³.

In the present application, for a test method of mechanical strength of a silicon wafer or a silicon substrate, refer to a fine ceramics bending strength test method GB/T 6569-2006. In the used test method, the bending strength refers to the maximum stress of a material when the material breaks under a bending load condition. In the present application, a curvature of the solar cell may be detected by using the method.

In the present application, a dispersion degree of mechanical strengths of silicon wafers or silicon substrates is used for representing strength uniformity of different silicon wafers prepared by using a same process. A lower dispersion degree indicates a smaller strength difference between different silicon wafers. Detection may be performed by using a test method known in the art. For example, the dispersion degree of mechanical strengths of silicon wafers is tested by using a single-column electronic universal testing machine.

In the present application, a doped region, for example, a region in which a Group-IIIA element (boron) is diffused in the following TOPcon solar cell, may be further configured to separate photogenerated carriers.

To be specific, the silicon substrate is obtained from a bare silicon wafer. The silicon substrate includes a silicon matrix and a doped region. The silicon matrix is a bulk region that is not doped in a solar cell process, and has performance the same as that of a bare silicon wafer as a raw material. The doped region may be a region in which a doping element is different from that of the bulk region, and other performance and parameters are basically the same as those of the bulk region, for example, a doped region formed through direct doping or internal diffusion doping inside the bare silicon wafer. In addition, in some cases, the doped region contains antimony and another doping element. The doping element is, for example, a Group-IIIA element or a Group-VA element, such as boron (B) or phosphorus (P). In some cases, the doped region may be basically the same as the bulk region, in other words, mainly includes an antimony doped region.

In a solar cell (e.g., a TOPcon solar cell, a local TOPcon solar cell, a back-contact hybrid cell, or a TBC solar cell) at least partially having a TOPcon structure, the silicon substrate usually includes a doped region formed on a surface of at least one side of the silicon substrate, and a part of performance of the doped region is the same as that of a bare silicon wafer as a raw material. The doped region may be a doped region in which a doping element is different from that of the bulk region, and other performance and parameters of the doped region are basically the same as those of the bulk region (to be specific, properties such as concentrations of antimony, resistivity variation rates, and resistivity offset rates of the doped region and the bulk region are basically the same). Such a doped region may be formed by using a bare silicon wafer through directly doping described in detail below, or may be formed by doping a doping element in the bare silicon wafer, for example, through layers such as a doping passivation layer and an interface passivation layer. In the present application, for the solar cell at least partially having the TOPcon structure, the doped region usually refers to a region formed through direct doping or internal diffusion doping inside a silicon wafer raw material. The internal diffusion doping is doping of polycrystalline silicon into a bare silicon wafer through a tunneling layer referred to as a passivation layer.

In a case of a crystal silicon heterojunction (HJT/HIT) cell or a full-back electrode heterojunction back-contact (HBC) cell, the doped region also refers to a doped region inside an inner surface of at least one side of the silicon substrate. In this case, the doped region includes antimony, and a doping element, for example, a Group-IIIA element or a Group-VA element, such as B or P. Alternatively, the doped region may be basically the same as the bulk region, in other words, mainly includes an antimony doped region. Further, a doped amorphous silicon layer as a doped layer and an intrinsic amorphous silicon layer as a passivation layer are provided on a surface of at least one side of the silicon substrate. In this case, the doping element may or may not enter the silicon wafer raw material.

In the present application, the term "substantially constant" means that the concentration of antimony is uniform in a thickness direction of the silicon substrate according to the present application. Although specific values may vary to some extent with the variation of detection sites, the overall difference in the concentration of antimony in the thickness direction shall not exceed 50%, 40%, 30%, 20%, 10%, 9%, 8%, 7%, 6%, 5%, 4%, 3%, 2%, or 1%. To be specific, the difference between a maximum value and a minimum value shall not exceed 50%, 40%, 30%, 20%, 15%, 10%, 9%, 8%, 7%, 6%, 5%, 4%, 3%, 2%, or 1% of the minimum value.

In the present application, a side length or thickness of the silicon wafer may be detected by using a length or thickness measuring method known in the art, for example, may be measured by using a micrometer.

In the present application, a projection length of an arc length of a chamfer connected between two adjacent sides of the silicon wafer may be detected by using a length measuring method commonly used by a person skilled in the art, for example, may be measured by using a micrometer.

In the present application, a total oxygen content of the silicon wafer or the silicon substrate may be detected by using any method known by a person skilled in the art. These methods may be selected by the person skilled in the art based on a requirement. For example, the total oxygen content may be detected by using a SIMS method. In a specific embodiment of the present application, a secondary ion mass spectrometry SIMS method is used to detect the total oxygen content of the silicon wafer or the silicon substrate.

The inventor of the present application has found that, as an atomic radius of antimony (Sb) or carbon (C) differs significantly from that of silicon (Si) (where a Sb/Si atomic radius ratio is approximately 1.3 and a C/Si atomic radius ratio is approximately 0.65), effectively adjusting a doping ratio of Sb to C can significantly suppress localized lattice distortion and reduce the increase in silicon wafer stress caused by doping. Meanwhile, C atom doping has no significant effect on the ionization energy and defect states of Sb. Overall, this approach can reduce the density of defect states inside a silicon rod and improve the minority carrier lifetime.

Furthermore, individual C atoms have a low diffusion coefficient and poor mobility in silicon wafers. However, co-doping Sb and C in the form of dimers (dimer) can limit the migration of Sb to a certain extent, further improving the problem of segregation and resolving the non-uniform distribution of a minority carrier lifetime among different rods in a same furnace and among different segments of a same rod. Consequently, the minority carrier lifetimes of a plurality of silicon wafers obtained from silicon rods are highly uniform.

The present application provides a silicon wafer. The silicon wafer includes antimony and carbon. A ratio of a doping concentration of antimony to a doping concentration of carbon ranges from 1:0.1 to 1:12.5.

The ratio of the doping concentration of antimony to the doping concentration of carbon may be, for example, 1:0.1, 1:0.2, 1:0.3, 1:0.4, 1:0.5, 1:0.6, 1:0.7, 1:0.8, 1:0.9, 1:1, 1:1.5, 1:2, 1:2.5, 1:3, 1:3.5, 1:4, 1:4.5, 1:5, 1:5.5, 1:6, 1:6.5, 1:7, 1:7.5, 1:8, 1:8.5, 1:9, 1:9.5, 1:10, 1:10.5, 1:11, 1:11.5, 1:12, 1:12.5, or within any range between these values.

By adopting a scheme of co-doping of antimony and carbon (Sb-C co-doping) and properly controlling a doping ratio of antimony to carbon, the present application can limit the migration of antimony, improve a minority carrier lifetime, and ensure a uniform distribution of the minority carrier lifetime.

In a specific embodiment, the doping concentration of carbon ranges from 4E+13 cm⁻³ to 2.5E+17 cm⁻³. For example, the doping concentration of carbon may be 4E+13 cm⁻³, 5.0E+13 cm⁻³, 6.0E+13 cm⁻³, 7.0E+13 cm⁻³, 8.0E+13 cm⁻³, 9.0E+13 cm⁻³, 1.0E+14 cm⁻³, 2.0E+14 cm⁻³, 3.0E+14 cm⁻³, 4.0E+14 cm⁻³, 5.0E+14 cm⁻³, 6.0E+14 cm⁻³, 7.0E+14 cm⁻³, 8.0E+14 cm⁻³, 9.0E+14 cm⁻³, 1.0E+15 cm⁻³, 2.0E+15 cm⁻³, 3.0E+15 cm⁻³, 4.0E+15 cm⁻³, 5.0E+15 cm⁻³, 6.0E+15 cm⁻³, 7.0E+15 cm⁻³, 8.0E+15 cm⁻³, 9.0E+15 cm⁻³, 1.0E+16 cm⁻³, 2.0E+16 cm⁻³, 3.0E+16 cm⁻³, 4.0E+16 cm⁻³, 5.0E+16 cm⁻³, 6.0E+16 cm⁻³, 7.0E+16 cm⁻³, 8.0E+16 cm⁻³, 9.0E+16 cm⁻³, 1.0E+17 cm⁻³, 2.0E+17 cm⁻³, 2.5E+17 cm⁻³, or within any range between these values.

In a specific embodiment, the doping concentration of antimony ranges from 4E+14 cm⁻³ to 2E+16 cm⁻³. For example, the doping concentration of antimony may be 4.0E+14 cm⁻³, 4.5E+14 cm⁻³, 5.0E+14 cm⁻³, 5.5E+14 cm⁻³, 6.0E+14 cm⁻³, 6.5E+14 cm⁻³, 7.0E+14 cm⁻³, 7.5E+14 cm⁻³, 8.0E+14 cm⁻³, 8.5E+14 cm⁻³, 9.0E+14 cm⁻³, 9.5E+14 cm⁻³, 1.0E+15 cm⁻³, 1.5E+15 cm⁻³, 2.0E+15 cm⁻³, 2.5E+15 cm⁻³, 3.0E+15 cm⁻³, 3.5E+15 cm⁻³, 4.0E+15 cm⁻³, 4.5E+15 cm⁻³, 5.0E+15 cm⁻³, 5.5E+15 cm⁻³, 6.0E+15 cm⁻³, 6.5E+15 cm⁻³, 7.0E+15 cm⁻³, 7.5E+15 cm⁻³, 8.0E+15 cm⁻³, 8.5E+15 cm⁻³, 9.0E+15 cm⁻³, 9.5E+15 cm⁻³, 1.0E+16 cm⁻³, 1.5E+16 cm⁻³, 2.0E+16 cm⁻³, or within any range between these values.

In a specific embodiment, when the doping concentration of antimony is greater than or equal to 4E+14 cm⁻³ and less than or equal to a, the ratio of the doping concentration of antimony to the doping concentration of carbon ranges from 1:b to 1:12.5, where a is selected from the range of 8E+15 cm⁻³ to 1.2E+16 cm⁻³, and b is greater than 0.1.

For example, a may be 8.0E+15 cm⁻³, 8.5E+15 cm⁻³, 9.0E+15 cm⁻³, 9.5E+15 cm⁻³, 1.0E+16 cm⁻³, 1.05E+16 cm⁻³, 1.1E+16 cm⁻³, 1.15E+16 cm⁻³, 1.2E+16 cm⁻³, or within any range between these values.

For example, b is greater than 0.1 and less than or equal to 12.5, and b may be 0.11, 0.15, 0.2, 0.25, 0.3, 0.35, 0.4, 0.45, 0.5, 0.55, 0.6, 0.65, 0.7, 0.75, 0.8, 0.85, 0.9, 0.95, 1.0, 1.5, 2.0, 2.5, 3.0, 3.5, 4.0, 4.5, 5, 5.5, 6.0, 6.5, 7.0, 7.5, 8.0, 8.5, 9.0, 9.5, 10, 10.5, 11.0, 11.5, 12.0, 12.5, or within any range between these values.

In a specific embodiment, a is selected from the range of 9E+15 cm⁻³ to 1.1E+16 cm⁻³.

In a specific embodiment, a is 1E+16 cm⁻³.

In a specific embodiment, b is greater than 0.5.

In a specific embodiment, b is greater than 0.7.

In a specific embodiment, a is selected from the range of 9E+15 cm⁻³ to 1.1E+16 cm⁻³, and b is greater than 0.5.

In a specific embodiment, a is selected from the range of 9E+15 cm⁻³ to 1.1E+16 cm⁻³, and b is greater than 0.7.

In a specific embodiment, a is 1E+16 cm⁻³, and b is greater than 0.5.

In a specific embodiment, a is 1E+16 cm⁻³, and b is greater than 0.7.

In a specific embodiment, when a is 1E+16 cm⁻³, to be specific, when the doping concentration of antimony is greater than or equal to 4E+14 cm⁻³ and less than or equal to 1E+16 cm⁻³, the ratio of the doping concentration of antimony to the doping concentration of carbon may be 1:0.11, 1:0.15, 1:0.2, 1:0.25, 1:0.3, 1:0.35, 1:0.4, 1:0.45, 1:0.5, 1:0.55, 1:0.6, 1:0.65, 1:0.7, 1:0.75, 1:0.8, 1:0.85, 1:0.9, 1:0.95, 1:1.0, 1:1.1, 1:1.2, 1:1.3, 1:1.4, 1:1.5, 1:1.6, 1:1.7, 1:1.8, 1:1.9, 1:2.0, 1:2.1, 1:2.2, 1:2.3, 1:2.4, 1:2.5, or within any range between these values.

In a specific embodiment, when the doping concentration of antimony is greater than a and less than or equal to 2E+16 cm⁻³, the ratio of the doping concentration of antimony to the doping concentration of carbon ranges from 1:0.1 to 1:c, where a is selected from the range of 8E+15 cm⁻³ to 1.2E+16 cm⁻³, and c is less than 0.8.

For example, a may be 8.0E+15 cm⁻³, 8.1E+15 cm⁻³, 8.2E+15 cm⁻³, 8.3E+15 cm⁻³, 8.4E+15 cm⁻³, 8.5E+15 cm⁻³, 8.6E+15 cm⁻³, 8.7E+15 cm⁻³, 8.8E+15 cm⁻³, 8.9E+15 cm⁻³, 9.0E+15 cm⁻³, 9.1E+15 cm⁻³, 9.2E+15 cm⁻³, 9.3E+15 cm⁻³, 9.4E+15 cm⁻³, 9.5E+15 cm⁻³, 9.6E+15 cm⁻³, 9.7E+15 cm⁻³, 9.8E+15 cm⁻³, 9.9E+15 cm⁻³, 1.0E+16 cm⁻³, 1.1E+16 cm⁻³, 1.2E+16 cm⁻³, or within any range between these values.

For example, c is greater than or equal to 0.1 and less than 0.8, and c may be 0.1, 0.11, 0.15, 0.2, 0.25, 0.3, 0.35, 0.4, 0.45, 0.5, 0.55, 0.6, 0.65, 0.7, 0.75, 0.8, or within any range between these values.

In a specific embodiment, a is selected from the range of 9E+15 cm⁻³, to 1.1E+16 cm⁻³.

In a specific embodiment, a is 1E+16 cm⁻³.

In a specific embodiment, c is less than 0.5.

In a specific embodiment, c is less than 0.3.

In a specific embodiment, a is selected from the range of 9E+15 cm⁻³ to 1.1E+16 cm⁻³, and c is less than 0.5.

In a specific embodiment, a is selected from the range of 9E+15 cm⁻³, to 1.1E+16 cm⁻³, and c is less than 0.3.

In a specific embodiment, a is 1E+16 cm⁻³, and c is less than 0.5.

In a specific embodiment, a is 1E+16 cm⁻³, and c is less than 0.3.

In a specific embodiment, when a is 1.0E+16 cm⁻³, to be specific, when the doping concentration of antimony is greater than 1.0E+16 cm⁻³ and less than or equal to 2E+16 cm⁻³, the ratio of the doping concentration of antimony to the doping concentration of carbon may be 1:0.1, 1:0.11, 1:0.15, 1:0.2, 1:0.25, 1:0.3, 1:0.35, 1:0.4, 1:0.45, 1:0.5, 1:0.55, 1:0.6, 1:0.65, 1:0.7, 1:0.75, 1:0.8, or within any range between these values.

In a specific embodiment, the silicon wafer has a resistivity of 0.3 Ω·cm to 10 Ω·cm. For example, the resistivity of the silicon wafer may be 0.3 Ω·cm, 0.4 Ω·cm, 0.5 Ω·cm, 0.6 Ω·cm, 0.7 Ω·cm, 0.8 Ω·cm, 0.9 Ω·cm, 1 Ω·cm, 1.1 Ω·cm, 1.2 Ω·cm, 1.3 Ω·cm, 1.4 Ω·cm, 1.5 Ω·cm, 1.6 Ω·cm, 1.7 Ω·cm, 1.8 Ω·cm, 1.9 Ω·cm, 2 Ω·cm, 2 Ω·cm, 2.5 Ω·cm, 3 Ω·cm, 3.5 Ω·cm, 4 Ω·cm, 4.5 Ω·cm, 5 Ω·cm, 5.5 Ω·cm, 6 Ω·cm, 6.5 Ω·cm, 7 Ω·cm, 7.5 Ω·cm, 8 Ω·cm, 8.5 Ω·cm, 9 Ω·cm, 9.5 Ω·cm, 10 Ω·cm, or within any range between these values.

In a specific embodiment, the resistivity of the silicon wafer ranges from 0.4 Ω·cm to 8 Ω·cm.

In a specific embodiment, the resistivity of the silicon wafer ranges from 0.5 Ω·cm to 6 Ω·cm.

In a specific embodiment, a minority carrier lifetime of the silicon wafer is greater than or equal to 200 microseconds, preferably greater than or equal to 300 microseconds, further preferably greater than or equal to 500 microseconds, and more preferably greater than or equal to 1300 microseconds.

The minority carrier lifetime of the silicon wafer is greater than or equal to 200 microseconds. To be specific, a minority carrier lifetime at a carrier injection level (including a minority carrier lifetime calculated when converting another carrier injection level into an injection level ranging from 1E+15 cm⁻³ to 3E+15 cm⁻³) at a carrier injection level ranging from 1E+15 cm⁻³ to 3E+15 cm⁻³ is greater than or equal to 200 microseconds, and may be, for example, 200 microseconds, 500 microseconds, 800 microseconds, 1000 microseconds, 1100 microseconds, 1200 microseconds, 1300 microseconds, 1400 microseconds, 1500 microseconds, 1600 microseconds, 1700 microseconds, 1800 microseconds, 1900 microseconds, 2000 microseconds, 2100 microseconds, 2200 microseconds, 2300 microseconds, 2400 microseconds, 2500 microseconds, 2600 microseconds, 2700 microseconds, 2800 microseconds, 2900 microseconds, 3000 microseconds, 3100 microseconds, 3200 microseconds, 3300 microseconds, 3400 microseconds, 3500 microseconds, 3600 microseconds, 3700 microseconds, 3800 microseconds, 3900 microseconds, 4000 microseconds, 4100 microseconds, 4200 microseconds, 4300 microseconds, 4400 microseconds, 4500 microseconds, 4600 microseconds, 4700 microseconds, 4800 microseconds, 4900 microseconds, 5000 microseconds, 5100 microseconds, 5200 microseconds, 5300 microseconds, 5400 microseconds, 5500 microseconds, 5600 microseconds, 5700 microseconds, 5800 microseconds, 5900 microseconds, 6000 microseconds, 6100 microseconds, 6200 microseconds, 6300 microseconds, 6400 microseconds, 6500 microseconds, 6600 microseconds, 6700 microseconds, 6800 microseconds, 6900 microseconds, 7000 microseconds, 7100 microseconds, 7200 microseconds, 7300 microseconds, 7400 microseconds, 7500 microseconds, 7600 microseconds, 7700 microseconds, 7800 microseconds, 7900 microseconds, 8000 microseconds, 8100 microseconds, 8200 microseconds, 8300 microseconds, 8400 microseconds, 8500 microseconds, 8600 microseconds, 8700 microseconds, 8800 microseconds, 8900 microseconds, 9000 microseconds, 9100 microseconds, 9200 microseconds, 9300 microseconds, 9400 microseconds, 9500 microseconds, 9600 microseconds, 10000 microseconds, 15000 microseconds, 20000 microseconds, 30000 microseconds, 40000 microseconds, 50000 microseconds, 60000 microseconds, 70000 microseconds, 80000 microseconds, 90000 microseconds, 10000 microseconds, 110000 microseconds, 120000 microseconds, 125000 microseconds, 129000 microseconds, or within any range between these values.

In a specific embodiment, a total oxygen content in the silicon wafer is less than 25 ppma. The total oxygen content in the silicon wafer may be, for example, 25 ppma, 24 ppma, 23 ppma, 22 ppma, 21 ppma, 20 ppma, 19 ppma, 18 ppma, 17 ppma, 16 ppma, 15 ppma, 14 ppma, 13 ppma, 12 ppma, 11 ppma, 10 ppma, 9 ppma, 8 ppma, 7 ppma, 6 ppma, 5 ppma, 4 ppma, 3 ppma, 2 ppma, or within any range between these values.

In a specific embodiment, the total oxygen content in the silicon wafer is less than 18 ppma.

In a specific embodiment, the total oxygen content in the silicon wafer is less than 14 ppma.

In a specific embodiment, the total oxygen content in the silicon wafer is greater than 2 ppma. In a specific embodiment, the total oxygen content in the silicon wafer is greater than 3 ppma. In a specific embodiment, the total oxygen content in the silicon wafer is greater than 4 ppma.

In a specific embodiment, the total oxygen content in the silicon wafer ranges from 2 ppma to 25 ppma. In a specific embodiment, the total oxygen content in the silicon wafer ranges from 3 ppma to 25 ppma. In a specific embodiment, the total oxygen content in the silicon wafer ranges from 4 ppma to 25 ppma. In a specific embodiment, the total oxygen content in the silicon wafer ranges from 2 ppma to 23 ppma. In a specific embodiment, the total oxygen content in the silicon wafer ranges from 3 ppma to 23 ppma. In a specific embodiment, the total oxygen content in the silicon wafer ranges from 4 ppma to 23 ppma. In a specific embodiment, the total oxygen content in the silicon wafer ranges from 2 ppma to 22 ppma. In a specific embodiment, the total oxygen content in the silicon wafer ranges from 3 ppma to 22 ppma. In a specific embodiment, the total oxygen content in the silicon wafer ranges from 4 ppma to 22 ppma.

In a specific embodiment, when the ratio of the doping concentration of antimony to the doping concentration of carbon ranges from 1:0.1 to 1:12.5, the doping concentration of carbon ranges from 4E+13 cm⁻³ to 5E+16 cm⁻³, and the doping concentration of antimony ranges from 4E+14 cm⁻³, to 2E+16 cm⁻³, the total oxygen content in the silicon wafer ranges from 2 ppma to 25 ppma.

In a specific embodiment, the silicon wafer further includes at least one of phosphorus, gallium, or germanium.

In a specific embodiment of the present application, antimony, instead of phosphorus, is doped in the silicon wafer of the present application as a Group-V doping element. In this case, a person skilled in the art may understand that, depending on a source of a raw material of the silicon wafer or a manner of extra addition in the raw material for crystal pulling, the prepared silicon wafer may further contain another element, for example, any one or two or three of phosphorus, gallium, and germanium, but is actively doped with only antimony as the Group-V doping element to replace phosphorus for doping.

In a specific embodiment, phosphorus is included in molten silicon for manufacturing a silicon wafer, to obtain a silicon wafer including both phosphorus and antimony. Because of a difference between an evaporation rate of antimony and that of phosphorus in a doping procedure, the effects of two dopants on the resistivity of a silicon ingot coexist in an initial stage of crystal pulling. As time progresses, the contribution of antimony diminishes gradually. When antimony is completely volatilized, namely in a late stage of crystal pulling, only a single dopant phosphorus is in effect, so that the head and the tail of the ingot have relatively close resistivity, thereby improving the uniformity of axial resistivity, and correspondingly also improving the uniformity of resistivity in the silicon wafer.

In a specific embodiment, gallium is included in molten silicon for manufacturing a silicon wafer, to obtain a silicon wafer including both gallium and antimony. Specifically, in a monocrystalline silicon preparation method, on the one hand, an appropriate amount of gallium is doped into a polysilicon material to introduce majority carrier holes, to obtain monocrystalline silicon with a preset resistivity. On the other hand, an appropriate amount of antimony is doped into the polysilicon material to introduce free electrons, which compensate for holes in the silicon crystal, especially those in the tail of a monocrystalline silicon rod, and reduce the concentration of the tail of the monocrystalline silicon rod, making the longitudinal resistivity distribution of the prepared monocrystalline silicon rod more uniform, thereby increasing the length of the monocrystalline silicon rod in production, and improving the resistivity uniformity of a silicon wafer sliced from the silicon rod.

In a specific embodiment, germanium is included in molten silicon for manufacturing a silicon wafer, to obtain a silicon wafer including both germanium and antimony. During the monocrystalline silicon preparation process, antimony doping leads to lattice variation due to high evaporation rate and large atomic radius. A trace amount of germanium is doped, where an outermost electron number of germanium, equal to that of silicon, is 4, so that the electrical properties of a silicon material cannot be affected. Instead, native micro-defects, especially void defects, in the monocrystalline silicon can be suppressed through effects of germanium and point defects (self-interstitial silicon atoms and vacancies), so that quality and a yield of the monocrystalline silicon can be effectively improved, and native defects can be suppressed, to improve quality of the crystal.

Usually, the concentration of phosphorus in the silicon wafer does not exceed 3E+16 atom/cm³. The concentration of gallium does not exceed 7E+16 atom/cm³. The concentration of germanium does not exceed 1E+19 atom/cm³. The foregoing concentration limits during simultaneous doping refer to respective concentration limits of the elements.

In a specific embodiment, a mechanical strength of the silicon wafer is greater than or equal to 70 MPa, and/or a dispersion degree of the mechanical strength of the silicon wafer is less than or equal to 0.9.

It should be noted that, if a side length of the silicon wafer is determined, the mechanical strength of the silicon wafer increases as the thickness of the silicon wafer increases.

The mechanical strength of the silicon wafer may be, for example, 70 MPa, 80 MPa, 90 MPa, 100 MPa, 110 MPa, 120 MPa, 140 MPa, 160 MPa, 180 MPa, 200 MPa, 210 MPa, 230 MPa, 250 MPa, 280 MPa, 300 MPa, 310 MPa, 320 MPa, 330 MPa, 340 MPa, 350 MPa, 360 MPa, 370 MPa, 380 MPa, 400 MPa, 500 MPa, or within any range between these values.

When a strength test is performed, a level detection platform is set, and two support beams are mounted on the level detection platform. A silicon wafer is placed on the two support beams, a span between the two support beams is 60 mm, and a thickness of the silicon wafer ranges from 40 µm to 170 µm. Then, push force is applied to the silicon wafer from top to bottom. Specific data of the applied pressure and a push distance are recorded by using a sensor, to measure a mechanical strength of the silicon wafer.

As competition of the photovoltaic industry is increasingly intensified, low costs become a core key, and thinning can effectively reduce costs of a silicon wafer and reduce optical attenuation of a solar cell, and the prepared solar cell has good flexibility. However, light absorption is reduced, warpage is easily caused, and the mechanical strength is greatly reduced during thinning. However, in the silicon wafer of the present application, by controlling the concentration of antimony, lattice glide is effectively hindered, to play a role in pinning a dislocation movement, thereby improving the mechanical strength of the silicon wafer.

In a specific embodiment, a dispersion degree of the mechanical strength of the silicon wafer is less than 0.9, and may be, for example, 0.89, 0.85, 0.8, 0.75, 0.7, 0.65, 0.6, 0.55, 0.5, 0.45, 0.4, 0.35, 0.3, 0.25, 0.2, 0.15, 0.1, or within any range between these values.

In the present application, the foregoing silicon wafer related in the present application is not further limited, and may be a silicon wafer (which may alternatively be referred to as a bare silicon wafer) obtained through machining and slicing after a silicon rod is pulled. The silicon substrate in the present application may be a local silicon substrate that is stripped and recovered from a solar cell module, provided that the silicon substrate can have a particular shape and can present a sheet shape, to be specific, have a size on one surface greater than a size of a surface perpendicular to the one surface, and have a flat shape or a sheet shape. The size of the silicon wafer or the silicon substrate in the present application is not limited either. The silicon wafer or the silicon substrate may be of any size. A light absorbing body and a stripped local silicon substrate from which another layer structure is stripped are recovered from the solar cell module. In addition, a person skilled in the art may understand that during striping, if a part of the doped region is damaged, as long as a part of the doped region that should also be understood as the silicon substrate described in the present application still exists, a solar cell having such a silicon substrate is also a solar cell satisfying the definition of the present application. For example, in a specific embodiment, a length of at least one side of the silicon wafer or the silicon substrate (including the part of the silicon substrate obtained by recycling and stripping the other layer structures) in the present application is greater than 156 mm, and may be, for example, 158±2 mm, 160±2 mm, 165±2 mm, 170±2 mm, 175±2 mm, 180±2 mm, 185±2 mm, 190±2 mm, 195±2 mm, 200±2 mm, 205±2 mm, 210±2 mm, 215±2 mm, 220±2 mm, 225±2 mm, 230±2 mm, 235±2 mm, 240±2 mm, 245±2 mm, 250±2 mm, 255±2 mm, 260±2 mm, 265±2 mm, 270±2 mm, 275±2 mm, or within any range between these values. For example, in a specific embodiment, a thickness of the silicon wafer or the silicon substrate (including the part of the silicon substrate obtained by recycling and stripping the other layer structures) in the present application at least ranges from 40 µm to 170 µm, and may be, for example, 40 µm, 50 µm, 60 µm, 70 µm, 80 µm, 90 µm, 100 µm, 110 µm, 120 µm, 130 µm, 140 µm, 150 µm, or 160 µm. In a specific embodiment, a size of the part of the silicon substrate obtained by recycling and stripping the other layer structures may be smaller than the foregoing size, provided that a concentration, a resistivity, a resistivity variation rate, an average resistivity offset rate, and other parameters of antimony tested thereon meet the limits specified in the present application.

In a specific embodiment, the silicon wafer is a rectangle, where one side of the rectangle has a length of 156 mm to 300 mm, and the other side has a length of 83 mm to 300 mm.

In a specific embodiment, the silicon wafer is a rectangle. A length of one side of the rectangle may be, for example, 156 mm, 160 mm, 170 mm, 180 mm, 190 mm, 200 mm, 210 mm, 220 mm, 230 mm, 240 mm, 250 mm, 260 mm, 270 mm, 280 mm, 290 mm, 300 mm, or within any range between these values. A length of the other side of the rectangle may be, for example, 83 mm, 85 mm, 90 mm, 95 mm, 100 mm, 110 mm, 120 mm, 130 mm, 140 mm, 150 mm, 160 mm, 170 mm, 180 mm, 190 mm, 200 mm, 210 mm, 220 mm, 230 mm, 240 mm, 250 mm, 260 mm, 270 mm, 280 mm, 290 mm, 300 mm, or within any range between these values.

A specific size of the silicon wafer, for example, the size described in detail in the silicon wafer involved in the present application, may be adjusted according to a specific application requirement.

In a specific embodiment, the silicon wafer further includes a chamfer connected between two adjacent sides of the silicon wafer. A projection length of an arc length of the chamfer ranges from 1 mm to 10 mm. For example, the projection length of the arc length of the chamfer may be 1 mm, 2 mm, 3 mm, 4 mm, 5 mm, 6 mm, 7 mm, 8 mm, 9 mm, 10 mm, or within any range between these values.

The present application relates to a solar cell prepared by using the foregoing silicon wafer.

The present application relates to a solar cell. The solar cell includes a case in which the foregoing silicon wafer described in detail in the present application is used for the solar cell. The detailed descriptions for the silicon wafer are substantially applicable. Specifically, the solar cell of the present application includes a silicon substrate. The silicon substrate includes a silicon matrix and a doped region inside a surface of at least one side of the silicon substrate. The silicon substrate contains antimony and carbon. The doped region is doped with a doping element. The doping element is selected from Group-IIIA elements or Group-VA elements. A ratio of a doping concentration of antimony to a doping concentration of carbon ranges from 1:0.1 to 1:12.5.

In a specific embodiment, a mechanical strength of the solar cell is greater than or equal to 50 Mpa. For example, the mechanical strength of the solar cell may be 50 Mpa, 55 Mpa, 60 Mpa, 65 Mpa, 70 Mpa, 75 Mpa, 80 Mpa, 85 Mpa, 90 Mpa, 95 Mpa, 100 Mpa, 105 Mpa, 110 Mpa, 115 Mpa, 120 Mpa, 125 Mpa, 130 Mpa, 135 Mpa, 140 Mpa, 145 Mpa, 150 Mpa, 155 Mpa, 160 Mpa, 165 Mpa, 170 Mpa, 175 Mpa, 180 Mpa, 185 Mpa, 190 Mpa, 195 Mpa, 200 Mpa or above or within any range between these values.

The foregoing descriptions for the silicon wafer in the present application are all applicable to the silicon substrate in the present application.

Because the concentration of antimony is properly controlled in the foregoing silicon wafer in the present application, uniform doping is implemented, so that the resistivity of the silicon wafer or the bare silicon wafer is uniform. Using such a silicon wafer to prepare a solar cell can reduce the transverse transfer resistance of carriers, thereby finally improving the efficiency of the solar cell. In addition, by using the silicon wafer of the present application, a minority carrier lifetime of the silicon wafer is relatively long, a short-circuit current of a prepared solar cell is improved, and solar cell efficiency is further improved.

In a specific embodiment, the silicon wafer of the present application may be used for manufacturing silicon substrates of various types of solar cells. The solar cells include an aluminum back surface field (Al-BSF) cell, a passivated emitter and rear contact (PERC) cell, a metal wrap through (MWT) cell, a passivated emitter rear locally diffused (PERL) cell, a passivated emitter rear totally diffused (PERT) cell, an emitter wrap-through (EWT) cell, a tunneling oxide passivated contact (TOPcon) cell, an interdigitated back-contact (IBC) cell, a crystal silicon heterojunction (HJT/HIT) cell, and a full-back electrode heterojunction back-contact (HBC) cell.

In a specific embodiment, the doping concentration of carbon in the silicon substrate of the present application ranges from 4E+13 cm⁻³ to 2.5E+17 cm⁻³. The doping concentration of antimony in the silicon substrate of the present application ranges from 4E+14 cm⁻³ to 2E+16 cm⁻³, preferably from 4.3E+14 cm⁻³ to 1.9E+16 cm⁻³, and further preferably from 4.45E+14 cm⁻³ to 1.87E+16 cm⁻³.

A person skilled in the art may understand that the foregoing silicon substrate is a structure formed after a solar cell is prepared from the foregoing silicon wafer of the present application. A person skilled in the art may understand that the foregoing solar cell encompasses all types of solar cells applicable to the foregoing silicon wafer of the present application, and may be, for example, a crystal silicon heterojunction (HJT/HIT) cell or a full-back electrode heterojunction back-contact (HBC) cell, or may be a TOPcon solar cell, a local TOPcon solar cell, a back-contact hybrid cell, a TBC solar cell, or any solar cell form well-known to a person skilled in the art.

In the foregoing cell form, at least one doped layer is provided on a surface of at least one side of the foregoing silicon substrate. Specifically, depending on different cell forms, the doped layer may be selected based on a requirement, and may be, for example, an n-type amorphous or polycrystalline silicon carbide layer, or may be, for example, phosphorus-doped silicon carbide, nitrogen-doped silicon carbide, phosphorus-doped amorphous silicon, or nitrogen-doped amorphous silicon, or may be an n-type amorphous or polycrystalline diamond-like carbon, for example, nitrogen-doped diamond-like carbon. A person skilled in the art can make a selection completely as required as long as a requirement of the present application is satisfied. A doped layer may be provided in at least some regions on a surface of at least one side of the silicon substrate, and another doped layer may be provided in other regions.

In the foregoing cell form, at least one passivation layer is provided between the foregoing doped layer and the doped region of the foregoing silicon substrate. Specifically, depending on different cell forms, the passivation layer may be selected based on a requirement. Usually, a thickness of the passivation layer should be less than 10 nm. Because the thickness is very small, there is no requirement on the electrical conductivity of the passivation layer. Because the thickness is small, there is no absorption limitation. Usually, the usable passivation layer includes silicon oxide, silicon nitride, intrinsic amorphous silicon, aluminum oxide, aluminum nitride, phosphorus nitride, titanium nitride, or the like. A person skilled in the art can make a selection completely as required as long as a requirement of the present application is satisfied.

In a specific embodiment, the foregoing solar cell is a heterojunction cell, and may be, for example, a crystal silicon heterojunction (HJT/HIT) cell or a full-back electrode heterojunction back-contact (HBC) cell. In the present application, when a silicon substrate formed by a silicon wafer is used as a heterojunction cell or a full-back electrode heterojunction back-contact cell, even after a heterojunction layer is stacked on the silicon substrate, the antimony concentration and the resistivity variation rate that are elaborated for the foregoing silicon wafer are still satisfied. To be specific, after the heterojunction layer is stacked, the concentration of antimony in the silicon matrix still ranges from 4E+14 cm⁻³ to 2E+16 cm⁻³, and the resistivity variation rate of the light absorbing body is still less than or equal to 0.6. All of the foregoing descriptions for the antimony concentration and the resistivity variation rate in the silicon wafer are applicable to this embodiment.

For a crystal silicon heterojunction (HJT/HIT) cell or a full-back electrode heterojunction back-contact (HBC) cell, usually, an intrinsic amorphous silicon layer and doped amorphous silicon are further stacked on the silicon substrate of the present application. The intrinsic amorphous silicon layer is used as a passivation layer. Due to characteristics of Sb, antimony in the silicon substrate does not enter the doped amorphous silicon layer through the passivation layer. The doped amorphous silicon layer substantially does not contain Sb. To be specific, the silicon substrate contains antimony, while the doped amorphous silicon layer or the intrinsic amorphous silicon layer contains a doping element but does not contain Sb.

Specifically, for a crystal silicon heterojunction (HJT/HIT) cell or a full-back electrode heterojunction back-contact (HBC) cell, the concentration of antimony in the foregoing silicon substrate ranges from 4.3E+14 cm⁻³ to 1.9E+16 cm⁻³. More specifically, the concentration of antimony in the foregoing silicon substrate ranges from 4.45E+14 cm⁻³ to 1.87E+16 cm⁻³

In a specific embodiment, for a TOPcon solar cell, a local TOPcon solar cell, a back-contact hybrid cell, or a TBC solar cell, the doped region described above contains a doping element, and the concentration of antimony in the doped region is substantially constant in a thickness direction of the silicon substrate. Therefore, the lattice distortion of crystalline silicon caused by single-element doping to cause many defects in a heavily-doped region can be overcome, and light absorption can be further improved, thereby improving the solar cell efficiency. A person skilled in the art may understand that for a TOPcon solar cell, a local TOPcon solar cell, a back-contact hybrid cell, and a TBC solar cell, in the present application, a doped region is formed inside a raw material silicon wafer through direct doping or formed by another layer structure through indirect doping. Therefore, in this case, the doped region is formed in the silicon substrate by allowing a doping element to enter the silicon wafer. An interfacial passivation layer and a doped passivation layer may be further stacked on a surface of at least one side of the silicon substrate. In addition, a person skilled in the art may understand that, as long as the structure of the solar cell has the structure described in detail in the present application, the structure with a different name also falls within the protection scope of the present application.

In the present application, the interfacial passivation layer is a layer that has a passivation function and allows a doping element to pass through, and may be, for example, a tunneling layer. The doped passivation layer refers to such a structure that a PN junction or a high-low junction is formed between the structure and the silicon matrix, for example, a doped amorphous silicon layer or a doped polycrystalline silicon layer.

A person skilled in the art may understand that, according to different application requirements of the silicon wafer, for example, when the silicon wafer is used in various solar cells, the foregoing silicon wafer may be further doped with various doping elements, and one or more doped regions are formed. These doping elements may be Group-IIIA elements, for example, boron, aluminum, gallium, indium, and thallium, or Group-VA elements, for example, nitrogen, phosphorus, arsenic, antimony, and bismuth.

In the present application, the concentration of antimony and the like described for the foregoing silicon wafer are also applicable to a silicon substrate that is mounted in a solar cell and used as a part of a light absorbing body. In this case, the foregoing parameters described for the concentration of antimony and the like in the silicon wafer are applicable to the entire silicon substrate, to be specific, are applicable to the bulk region doped with only antimony, are also applicable to the doped region, and are also applicable to the bulk region and the doped region as a whole. A person skilled in the art may understand that, when the foregoing detection is performed on only the bulk region, results obtained by measurement or calculation of the concentration of antimony, the resistivity, the resistivity variation rate, and the average resistivity offset rate of the bulk region fall within the ranges described in detail in the present application. When the foregoing detection is performed on only the doped region, a result obtained by measurement or calculation of the concentration of antimony falls within the range described in detail in the present application. The foregoing results can be similarly obtained when the boundary between the doped region and the bulk region is ignored and any site on the entire silicon substrate is detected.

In a specific embodiment, a manner in which the doped region is doped with the doping element may be direct doping. To be specific, the doped region is directly doped with the doping element without passing through another layer structure of the solar cell. The direct doping manner may be various methods known in the art. For example, the direct doping manner may be thermal diffusion, ion injection, or coating with a paste containing a dopant, where the dopant is added through a driving force (for example, thermal treatment or laser). The direct doping manner may be selected by a person skilled in the art according to a requirement. In addition, the direct doping manner also includes a case in which aluminum is diffused from an aluminum grid line into a silicon wafer through thermal treatment.

In a specific embodiment, other than the foregoing direct doping, a manner in which the doped region is doped with the doping element may alternatively be a doping element passing through the foregoing layer structure stacked on the silicon wafer or the silicon substrate to form the foregoing doped region. A person skilled in the art may understand that, the layer structure may be correspondingly adjusted according to different application scenarios of the silicon wafer, for example, when the silicon wafer is used for different solar cells. For example, the layer structure itself may contain a dopant providing a doping element. In this case, the doping element is added through the layer structure. Alternatively, the layer structure itself may not contain a dopant, but a region adjacent to the layer structure has an atmosphere capable of providing a doping element, and the silicon wafer is doped with the doping element through, for example, thermal diffusion or ion injection to form a doped region. The foregoing atmosphere capable of providing the doping element may be a gas atmosphere (e.g., a gas including a dopant), may be a liquid (e.g., a paste including a dopant), or may be a solid (e.g., a layer including a dopant, for example, a doped passivation layer, or particularly a doped polycrystalline silicon layer).

The layer structure may be one layer (e.g., a passivation layer or a tunneling layer), or may be a plurality of layers. For example, a passivation layer and a doped layer are used as the layer structure together. The layer structure may be an auto-oxidation layer formed by auto-oxidation on a silicon matrix. Alternatively, intrinsic amorphous silicon may be used as the layer structure, that is, intrinsic amorphous silicon that plays a passivation role is disposed on a side of the silicon wafer.

Using a TOPcon solar cell structure as an example, a doped polysilicon layer (a doped passivation layer) or a tunneling layer (an interfacial passivation layer) may function as a layer structure, or a doped polysilicon layer and a tunneling layer may jointly function as a layer structure. It will be fully understood by a person skilled in the art that the foregoing listing is merely exemplary. The direct doping and the doping by using a layer structure are both optional, and the direct doping and the doping by using a layer structure may be performed on a part on a side of a silicon wafer. For example, a part is doped with a doping element through the direct doping, and a TOPcon structure is stacked on another region on a surface on the side to form a local TOPcon structure or form a back-contact hybrid cell having a TOPcon structure. Alternatively, even a TOPcon structure may be locally used, and another TOPcon structure may be used in another position, to separately implement doping, for example, to form a TBC solar cell.

A person skilled in the art may understood that, in a case of a TOPcon structure, a tunneling layer and a doped polysilicon layer are further stacked on the silicon substrate. The concentration of antimony in the silicon substrate ranges from 4E+14 cm⁻³ to 2E+16 cm⁻³, preferably from 4.3E+14 cm⁻³ to 1.9E+16 cm⁻³, and further preferably from 4.45E+14 cm⁻³ to 1.87E+16 cm⁻³. The total oxygen content in the silicon substrate is less than 35 ppma, preferably less than 25 ppma, and further preferably less than 18 ppma.

In a specific embodiment, in a case of the direct doping, within a range of a thickness h from a surface on a side of the doped region away from the silicon substrate (i.e., a doped region depth of a directly doped region), on the surface and in a position at a same depth away from the surface, a concentration of the doping element is greater than a concentration of antimony.

In addition, in the doped region, a sum of the concentration of antimony and a concentration of the doping element is less than or equal to 1E+21 cm⁻³. According to the solar cell of the present application, because a range of a sum of a concentration in a doped region and a concentration of a doping element is controlled, carrier separation is facilitated, carrier recombination is reduced, and a short-circuit current and an open-circuit voltage are increased.

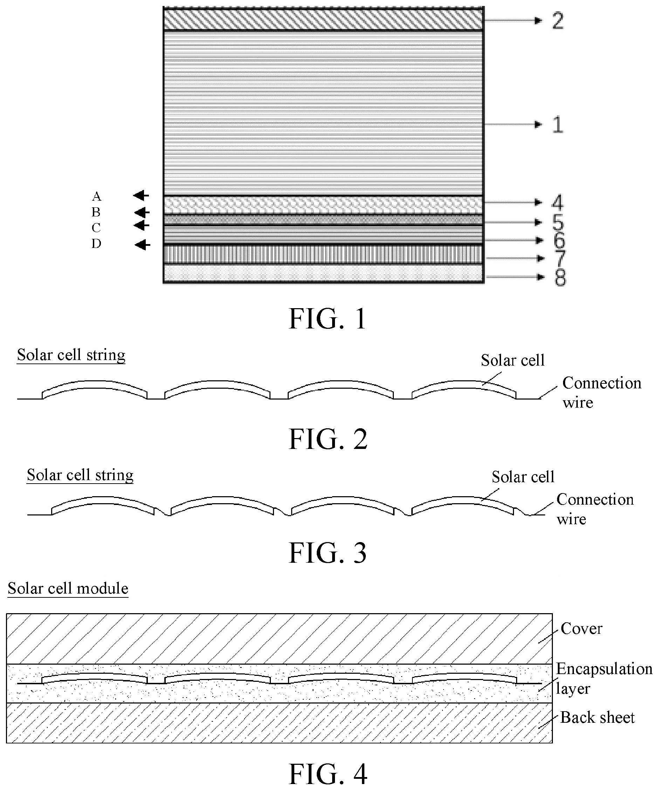

In a specific embodiment, the doping element is a Group-IIIA element, and h ranges from 30 nm to 650 nm. In a specific embodiment, the doping element is a Group-IIIA element, and h is greater than or equal to 400 nm. In a specific embodiment, the doping element is a Group-IIIA element, and h ranges from 30 nm to 100 nm. In a specific embodiment, the doping element is a Group-VA element, and h ranges from 100 mm to 200 mm. As described above, a maximum range in the position at the same depth away from the surface should be the thickness h. For example, when the depth is 0, the concentration in the foregoing doped region is the concentration on the surface of the foregoing doped region. When the depth is 100 nm, for example, at a position 100 nm from the foregoing surface, the concentration of the doping element is greater than the concentration of antimony. In a specific embodiment, as shown in FIG. 1, a surface on a side of the doped region away from the silicon matrix is a front face of doped region 2.

In a specific embodiment, the doping element is boron, and h ranges from 30 nm to 650 nm or h ranges from 30 nm to 100 nm. When only local doping is performed, only a position of the local doping needs to satisfy the foregoing relationship.

In the present application, because the thickness of the doped region formed by direct doping in the silicon substrate of the foregoing solar cell is controlled, carrier separation is facilitated, carrier recombination is reduced, and a short-circuit current and an open-circuit voltage are increased.

In a specific embodiment, if the thickness of the doped region formed by direct doping, for example, the thickness of the doped region doped with a Group-IIIA element, is further controlled to even be less than 100 nm or even to be less than 50 nm, Auger recombination of free carriers may be further reduced, and the short-circuit current is further improved. In a specific embodiment, in a case of performing diffusion through the layer structure, within a range of a thickness m from a surface on a side of the doped region away from the silicon substrate (the depth of the doped region in a case that the layer structure is used for diffusion), on the surface and in a position at a same depth away from the surface, a concentration of the doping element is greater than a concentration of antimony. In a specific embodiment, as shown in FIG. 1, a surface on a side of the doped region away from the silicon substrate is a back face of doped region 4.

In a specific embodiment, the doping element is a Group-IIIA element, and m ranges from 80 nm to 180 nm. In a specific embodiment, the doping element is a Group-VA element, and m ranges from 30 mm to 100 mm. As described above, a maximum range in the position at the same depth away from the surface should be less than or equal to m. For example, when the depth is 0, the concentration in the foregoing doped region is the concentration on the surface of the foregoing doped region. When the depth is 100 nm, for example, at a position 100 nm from the foregoing surface, the concentration of the doping element is greater than the concentration of antimony.

In a specific embodiment, the doping element is phosphorus, and m ranges from 80 mm to 180 mm or m ranges from 30 nm to 100 nm. When only local doping is performed, only a position of the local doping needs to satisfy the foregoing relationship.

In the present application, because the thickness of the doped region formed by the layer structure through doping is controlled, the foregoing light absorbing body not only retains a passivation effect of the interfacial passivation layer, but also implements effective doping of the polycrystalline silicon, thereby increasing a short-circuit current and an open-circuit voltage, and increasing efficiency of the solar cell.

In a specific embodiment, the solar cell of the present application is, for example, a tunneling oxide passivated contact cell (TOPcon solar cell), a local TOPcon solar cell, a back-contact hybrid cell, or a TBC solar cell.

In a specific embodiment, a typical structure of the TOPcon solar cell is shown in FIG. 1, and sequentially includes a silicon substrate 1 (a second doped region 2 and a first doped region 4 are formed inside surfaces on two sides of the silicon substrate), a tunneling layer 5, a doped polycrystalline silicon layer 6, a passivation layer or high-transfer film layer 7, and an electrode 8 in a direction from a front face to a back face. It will be fully understood by a person skilled in the art that although the structure of the TOPcon solar cell is described with reference to FIG. 1, the structure of the TOPcon solar cell is not limited to the structure in FIG. 1, provided that the silicon substrate of the solar cell has a tunneling layer and a doped polycrystalline silicon layer. The TOPcon structure may be formed on the entire silicon substrate or may be formed on at least some regions of the silicon substrate.

In a specific embodiment, the second doped region 2 is directly doped with boron, and the first doped region 4 is doped with phosphorus in the silicon substrate through the tunneling layer 5 and the doped polycrystalline silicon layer 6.

The local TOPcon solar cell means that a TOPcon structure (i.e., a first doped region, a tunneling layer, and a doped polycrystalline silicon layer) is formed on at least some regions of one surface of the solar cell, a first local region has the first doped region, the tunneling layer, and the doped polycrystalline silicon layer, and regions other than the first local region are other doped regions. The other doped regions and the first doped region are on a same surface, elements with which the other doped regions and the first doped region are doped are the same in conduction type, but the other side is doped with an element having an opposite conduction type, to form a second doped region.

The TBC solar cell means that a TOPcon structure is formed on the back face of the solar cell, there are two regions on the back face of the solar cell, and the two regions respectively have TOPcon structures with doping elements in opposite conduction types.

The back-contact hybrid cell refers to a solar cell in which one region has a PERC or PERL structure and the other region has a TOPcon structure. For example, one region of the back face has a TOPcon structure, the other region has a PERL or PERC structure, and the two regions are doped with elements having opposite conduction types. In a specific embodiment, when an aluminum grid line is used for doping, a metal layer is formed on the silicon substrate, and an alloy layer and a BSF layer are formed in the silicon substrate. The BSF layer is a doped region. In this case, a surface on a side of the doped region away from the silicon matrix refers to a surface on a side of the BSF layer away from the silicon substrate.

In these four types of solar cells, the foregoing doping element is doped into the silicon substrate through the layer structure on the silicon substrate to form the foregoing doped region. The foregoing doped region includes a first doped region and a second doped region. The layer structure on the silicon substrate includes a tunneling layer and a doped polycrystalline silicon layer that are sequentially stacked on a surface on a side of the first doped region away from the silicon substrate. A first doping element is doped into the doped polysilicon layer, and a second doping element is also doped into the second doped region on the foregoing silicon substrate. The first doped region and the second doped region have opposite conductivity types.

In the present application, the "first doping element" and the "second doping element" are different doping elements. For example, when the first doping element is a Group-VA element, the second doping element is a Group-IIIA element. When the first doping element is a Group-IIIA element, the second doping element is a Group-VA element.

In a specific embodiment, the first doping element is phosphorus, and the second doping element is boron.

When the solar cell in the present application is a TOPcon solar cell, a local TOPcon solar cell, or a back-contact hybrid cell, the second doped region is obtained by directly doping the second doping element into the second doped region. The first doping element is a Group-VA element (e.g., phosphorus), and the second doping element is a Group-IIIA element (e.g., boron).

In a specific embodiment, in the doped polycrystalline silicon layer, a concentration of the first doping element at a depth x (i.e., a first preset depth) away from a surface on a side of the doped polycrystalline silicon layer away from the silicon substrate is greater than a concentration of the second doping element at the depth x (i.e., the first preset depth) away from a surface of the second doped region, a thickness of the doped polycrystalline silicon layer ranges from 100 nm to 400 nm, and x is less than or equal to the thickness of the doped polycrystalline silicon layer. In this embodiment, because the concentration of the first doping element is greater than the concentration of the second doping element, Auger recombination of free carriers can be further reduced, and the short-circuit current can be further improved. In a specific embodiment, in a direction from the doped polycrystalline silicon layer to the tunneling layer, in the tunneling layer, a concentration of the first doping element at a depth y (i.e., a second preset depth) away from a surface of a side of the doped polycrystalline silicon layer away from the silicon substrate is greater than a concentration of the second doping element at the depth y (i.e., the second preset depth) away from a surface of the second doped region, a thickness of the tunneling layer ranges from 0.5 nm to 5 nm, and y is less than or equal to a sum of thicknesses of the doped polycrystalline silicon layer and the tunneling layer. In this embodiment, because the concentration of the first doping element is greater than the concentration of the second doping element, Auger recombination of free carriers can be further reduced, and the short-circuit current can be further improved. In another aspect, Auger recombination of free carriers can be reduced without reducing a passivation effect of a tunneling layer, thereby further improving the short-circuit current, the open-circuit voltage, and the solar cell efficiency. In a specific embodiment, in a direction from the doped polycrystalline silicon layer to a surface of the first doped region, in the silicon substrate, a concentration of the first doping element at a depth z (i.e., a third preset depth) away from a surface of a side of the doped polycrystalline silicon layer away from the silicon substrate is greater than a concentration of the second doping element at the depth z (i.e., the third preset depth) away from a surface of the second doped region, a thickness of the first doped region ranges from 30 nm to 100 nm, and z is less than or equal to a sum of thicknesses of the doped polycrystalline silicon layer, the tunneling layer, and the first doped region. In this embodiment, because the concentration of the first doping element is greater than the concentration of the second doping element, Auger recombination of free carriers can be further reduced, and the short-circuit current can be further improved. In another aspect, Auger recombination of free carriers can be reduced without reducing a passivation effect of a tunneling layer, thereby further improving the short-circuit current, the open-circuit voltage, and the solar cell efficiency.

As described above, a distribution situation of element concentration of a doped region of a silicon substrate of a solar cell is described in detail. Positions of x, y, and z are described with the help of a TOPcon solar cell shown in FIG. 1. As shown in FIG. 1, a surface on a side of the doped polycrystalline silicon layer away from the silicon substrate is a surface shown by D, where a maximum value of x is a distance between D and C, a maximum value of y is a distance between D and B, and a maximum value of z is a distance between D and A.

When the solar cell of the present application is a TBC solar cell, the first doping element is a Group-VA element (e.g., phosphorus), and the second doping element is a Group-IIIA element (e.g., boron). The layer structure on the silicon substrate further includes a second layer structure. The second layer structure includes a tunneling layer and a doped polycrystalline silicon layer that are sequentially stacked on a surface on a side of the second doped region away from the silicon substrate. The second doped region is a doped region formed by the second doping element passing through the second layer structure on the silicon substrate.

In a specific embodiment, in the doped polycrystalline silicon layer, a concentration of the first doping element at a depth x (namely, a first preset depth) away from a surface of a side of the doped polycrystalline silicon layer of the first doped region away from the silicon substrate is greater than a concentration of the second doping element at the depth x (i.e., the first preset depth) away from a surface of a side of the doped polycrystalline silicon layer of the second doped region away from the silicon substrate, a thickness of the doped polycrystalline silicon layer on the first doped region ranges from 100 nm to 400 nm, a thickness of the doped polycrystalline silicon layer on the second doped region ranges from 100 nm to 400 nm, and x is less than or equal to the thickness of the doped polycrystalline silicon layer on the first doped region. In a specific embodiment, a first doping element is doped into the tunneling layer of the first doped region, and a second doping element is doped into the tunneling layer of the second doped region. In a direction from the doped polysilicon layer to the tunneling layer, in the tunneling layer, a concentration of the first doping element at a depth y (i.e., a second preset depth) away from a surface of a side of the doped polycrystalline silicon layer of the first doped region away from the silicon substrate is greater than a concentration of the second doping element at the depth y (i.e., the second preset depth) away from a surface of a side of the doped polycrystalline silicon layer of the second doped region away from the silicon substrate, a thickness of the doped polycrystalline silicon layer on the first doped region ranges from 0.5 nm to 5 nm, a thickness of the tunneling layer on the second doped region ranges from 0.5 nm to 5 nm, and x is less than or equal to a sum of thicknesses of the doped polycrystalline silicon layer and the tunneling layer on the first doped region. In a specific embodiment, in a direction from the doped polycrystalline silicon layer to a surface of the first doped region, in the silicon substrate, a concentration of the first doping element at a depth z (i.e., a third preset depth) away from a surface of a side of the doped polycrystalline silicon layer of the first doped region away from the silicon substrate is greater than a concentration of the second doping element at the depth z (i.e., the third preset depth) away from a surface of a side of the doped polycrystalline silicon layer of the second doped region away from the silicon substrate, a thickness of the first doped region ranges from 30 nm to 100 nm, and z is less than or equal to a sum of thicknesses of the doped polycrystalline silicon layer and the tunneling layer on the first doped region, and the first doped region.

In the present application, regardless of a TOPcon solar cell, a local TOPcon solar cell, a back-contact hybrid cell, or a TBC solar cell, because the silicon substrate is uniformly doped with both antimony and a doping element, and an resistivity of the silicon substrate and the light absorbing body is very uniform, a transverse transfer resistance of a carrier can be effectively reduced, and the solar cell efficiency can be effectively improved.

In a specific embodiment, the solar cell of the present application includes an electrode formed on a light absorbing body. The electrode includes a metallic crystal part in contact with the light absorbing body. The metallic crystal part includes antimony. The light absorbing body includes a silicon substrate and a region for separating carriers generated by the silicon substrate.

In the present application, the metallic crystal refers to an alloy formed by metal in the electrode and silicon in a procedure of forming the electrode.

In a specific embodiment, the metallic crystal part further includes a doping element. A concentration of the doping element is greater than a concentration of antimony.

Because the metallic crystal part of the electrode of the solar cell of the present application contains antimony, contact resistance of the solar cell can be reduced and the contact resistance of the solar cell can be further reduced.

In a specific embodiment, a mechanical strength of the solar cell of the present application is greater than or equal to 50 MPa.

The present application further includes a solar cell string structure, including a plurality of solar cells of the present application that are connected to each other by using a conductive interconnection member.

In a specific embodiment, the conductive interconnection member may be, for example, a conductive connection wire (sometimes also referred to as a metal solder strip), or may be a conductive trace in a conductive back sheet.

Specifically, before forming a photovoltaic module, the solar cells need to undergo a stringing (or string soldering) step. Specifically, referring to FIG. 2, a plurality of solar cells are connected by using a plurality of conductive connection wires, and may be, for example, connected in series. The conductive connection wire may be a metal line structure, a cross section of the conductive connection wire may be a circular cross section, a triangular cross section, or the like, and the conductive connection wire may be formed by a base body and a bonding layer wrapped around the base body.

In the present application, whether the connection is performed by using the conductive connection wire (metal solder strip) or the conductive trace formed on the conductive back sheet, it is only required that the solar cell is in contact with the conductive interconnection member through the electrode, and the contact part includes antimony. Such a structure can further reduce the contact resistance of the solar cell string.

In the stringing step, an electrical connection is performed through soldering. In the soldering procedure, a heating operation needs to be performed, mainly aiming to fuse the bonding layer of the connection wire to form an electrical connection with the solar cell. However, in the heating step, the top-bottom stress of the solar cell may be uneven, and the top-bottom uneven pressure may cause bending. However, a larger bending in the stringing procedure indicates a larger risk of hidden cracking and fragmentation of the solar cell during laminating. However, the mechanical strength of the solar cell involved in the present application is greater than 50 Mpa. A relatively large mechanical strength can suppress excessive bending of solar cells when being stringed, which can improve the module yield to some extent. Generally speaking, the curvature of the back-contact solar cell is slightly larger than that of a bifacial solar cell, which is due to a greater stress difference between the top and bottom surfaces of the back-contact solar cell. The back-contact solar cell means that an electrical interconnection structure is provided on only one surface of the solar cell, and the bifacial solar cell means that an electrical interconnection structure is provided on each of two opposite surfaces of the solar cell.

Specifically, referring to FIG. 2, the curvature of the back-contact solar cell is less than or equal to 2 mm after undergoing stringing at a heating temperature of 165 to 200°C, and the curvature of the back-contact solar cell is less than or equal to 1.5 mm after undergoing stringing at a heating temperature of 100 to 160°C. Referring to FIG. 3, the curvature of the bifacial solar cell is less than or equal to 1.2 mm after undergoing stringing at a heating temperature of 165 to 200°C, and the curvature of the bifacial solar cell is less than or equal to 1 mm after undergoing stringing at a heating temperature of 100 to 160°C. It may be learned that, the specially doped solar cell of the present application has a relatively small curvature, which can well control problems of hidden cracking and fragmentation during laminating. It should be noted that the curvature involved in the present application refers to a height or a depth of a protrusion or a recess that is generated on a surface of a solar cell when the solar cell is bent, and may be obtained by measuring a curvature radius of an edge of the solar cell.

The present application further relates to a solar module, including a plurality of solar cells of the present application, an encapsulation layer, a cover, and a back sheet. The plurality of solar cells are encapsulated in the encapsulation layer, and the encapsulation layer is located between the cover and the back sheet.

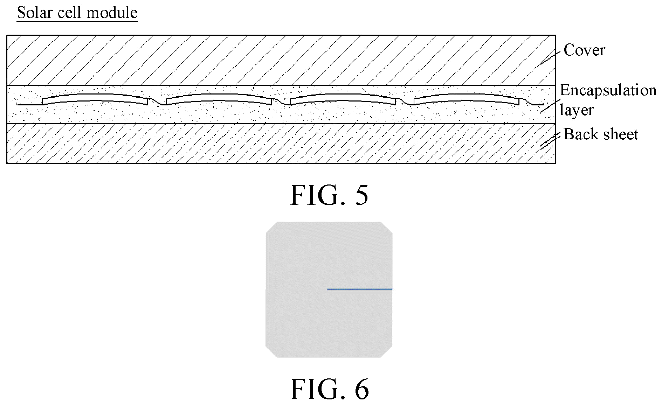

A solar cell string in the present application is formed into a solar cell module through processes such as layout, superposing, and laminating. For the formed solar cell module, refer to FIG. 4 and FIG. 5. When a laminating process is performed, pressure application and heating are required, so that the encapsulation layer is configured to fuse and seal the solar cell string, and is attached to the cover and the back sheet. The encapsulation layer is located between the cover and the back sheet. In the laminating process, partial stress of the solar cells is relieved and suppressed due to the application of pressure and heat. For back-contact solar cells, referring to FIG. 4, the curvature of the solar cells in the laminated solar cell module is less than or equal to 1.2 mm. For bifacial solar cells, referring to FIG. 5, the curvature of the solar cells in the laminated solar cell module is less than 0.8 mm. It is verified that the problems of hidden cracking and fragmentation of the laminated solar cell are significantly controlled. It can be seen from FIG. 3 and FIG. 5 that, a bending direction of the solar cell is toward the cover, that is, the solar cell projects toward the cover to form a curved shape.

Specifically, the encapsulation layer may be at least one of EVA, POE, silica gel, and PVB. The cover is close to a light receiving surface of the solar cell, and is transparent and organic or organic. Preferably, the cover may be low-iron patterned glass. The thickness of the cover is preferably 2.0 or 3.2 mm. The back sheet may be a transparent or non-transparent material. For a double-glazed module, the back sheet is a transparent material, and is preferably glass. For a single-glazed module, the back sheet may be non-transparent, and may be, for example, a TPC sheet. Further, the solar cell module further includes a frame. The frame has a slot-shaped mounting part for accommodating a laminate. Edges of the cover and the back sheet are embedded in the mounting part of the frame.

In the present application, the resistivity of the silicon wafer or the silicon substrate may be detected by using any method known by a person skilled in the art, and these methods may be selected by the person skilled in the art based on a requirement. For example, the resistivity may be detected by using a four-probe tester, or may be detected by using a method such as a non-contact eddy current method (e.g., detected by using a terahertz offline two-dimensional imaging device (FalconWave-S)). Preferably, the resistivity is detected by using a four-probe tester. A person skilled in the art may understand that the resistivity of the silicon wafer or the silicon substrate may refer to resistivity detection data of any site on the surface of the silicon wafer or the silicon substrate or in the middle of the silicon wafer or the silicon substrate, and certainly may alternatively be an average value of resistivity detection data of a plurality of positions or an average value of resistivity of the entire silicon wafer or silicon substrate. A person skilled in the art may select the foregoing any site for detection based on a detection condition and a used instrument and based on an actual situation, or may calculate an average value of a plurality of sites after detecting the plurality of sites and use the average value as the resistivity of the silicon wafer or the silicon substrate. In a specific embodiment, the resistivity of the silicon wafer or the silicon substrate refers to an average value of the resistivity detected across the thickness of the silicon wafer or the silicon substrate. For example, the resistivity at various sites of the silicon wafer or the silicon substrate is detected in a thickness direction by using a four-probe tester, and then an average value in the thickness direction is calculated.

In the present application, the resistivity variation rate of the silicon wafer or the silicon substrate refers to a value calculated by subtracting a minimum value from a maximum value of the resistivity at any site of the silicon wafer or the silicon substrate and then dividing an average value of the resistivity at any site of the silicon wafer or the silicon substrate. For example, a person skilled in the art can select any site on the surface of the silicon wafer or the silicon substrate or in the silicon wafer or the silicon substrate, perform detection by using a method such as a non-contact eddy current method (e.g., detection by using a terahertz offline two-dimensional imaging device (FalconWave-S)) or by using a four-probe tester, analyze the resistivity of n tested sites, select a maximum value and a minimum value, and calculate an average value and a resistivity variation rate of the silicon wafer or the silicon substrate. It will be fully understood by a person skilled in the art that n may be any positive integer greater than or equal to 2, and may usually be, for example, a positive integer greater than 3, 4, 5, 6, 7, 8, 9, 10, 11, 12, 13, 14, 15, 16, 17, 18, 19, 20, 25, 30, 35, 40, 45, 50, 55, 60, 65, 70, 75, 80, 85, 90, 95, or 100. It is also feasible to scan the entire surface of the silicon wafer or the silicon substrate, obtain an average value of the resistivity at any site on the surface of the silicon wafer or the silicon substrate in a direction perpendicular to the surface of the silicon wafer or the silicon substrate by using an instrument, select a maximum resistivity value Rₘₐₓ and a minimum resistivity value Rₘᵢₙ from scanning results of the entire surface, calculate an average resistivity value Rᵥ, and calculate a resistivity variation rate of the silicon wafer or the silicon substrate by using a calculation formula of resistivity variation rate: (Rₘₐₓ-Rₘᵢₙ)/Rᵥ. In practical operation, the resistivity variation rate of the silicon wafer or the silicon substrate may be tested by using the following method: performing resistivity surface scanning on the silicon wafer or the silicon substrate by using a terahertz offline two-dimensional imaging device (FalconWave-S) or a four-probe tester; selecting a line from a center point of the silicon wafer or the silicon substrate to an edge of the silicon wafer or the silicon substrate, as shown in FIG. 6, where the black line in FIG. 6 represents the selected line; and obtaining an average resistivity value Rᵥ of the silicon wafer or the silicon substrate on the selected line, and obtaining a maximum resistivity value Rₘₐₓ and a minimum resistivity value Rₘᵢₙ of the silicon wafer or the silicon substrate on the selected line, where the resistivity variation rate is (Rₘₐₓ-Rₘᵢₙ)/Rᵥ. In addition, it will be fully understood by a person skilled in the art that the black line shown in FIG. 6 is merely exemplary. Any line may be drawn on the silicon wafer or the silicon substrate to detect the resistivity variation rate of the silicon wafer or the silicon substrate.

### Embodiments

Materials and test methods used in the test are generally and/or specifically described in the present application. In the following embodiments, % represents wt%, namely a weight percentage, if no other particular descriptions are provided. Reagents or instruments used do not indicate the manufacturer and are conventional reagent products commercially available.

### Embodiment 1

A quartz crucible was loaded with a polycrystalline silicon block. For example, a solid silicon raw material was first placed in the quartz crucible, and then the quartz crucible filled with the silicon material was placed in a single crystal furnace.

The single crystal furnace was vaccumized, a heater of the single crystal furnace was turned on, and the solid silicon in the quartz crucible was gradually melted into a molten state.

Because the solid silicon material in the quartz crucible occupies, after being heated and melted, the decreased actual volume in the quartz crucible and the melted silicon material does not reach a maximum loading amount of the quartz crucible, the quartz crucible needs to be filled with the silicon material for the second time by using an external loader such as a quartz tube loading barrel. In this embodiment, loading needs to be performed by using the quartz tube, and in a loading procedure, the heater synchronously performs melting treatment on the silicon material in the quartz crucible.

A Sb-containing dopant and the silicon material were added to the quartz crucible together. After the silicon material in the quartz crucible is all melted, switching to a temperature regulation step, a seed crystal was inserted into a silicon liquid, and a critical crystallization temperature of a liquid surface temperature was reached by controlling a power parameter and the like. In the Sb-containing dopant, a doping concentration of antimony was 4E+14 cm⁻³, a doping concentration of carbon was 4E+13 cm⁻³, and a ratio of the doping concentration of antimony to the doping concentration of carbon was 10:1.

The seed crystal was pulled upward after the seed crystal and the liquid surface reached the crystallization temperature point.

After the length of the seed crystal reached a required length of 15 to 20 mm and the diameter of the seed crystal was within 5 to 10 mm, an actual single crystal diameter was set to be within a range of 252 ± 1 mm round rod diameter by adjusting parameters such as a power and a pulling speed. After the shoulder growth was completed, the process transitioned from shoulder turning to the constant-diameter growth stage of a silicon rod.

In the diameter equaling procedure, the pull speed, the power, and the like were adjusted, until a diameter equaling length was 3800 mm.

The diameter of the silicon rod was reduced to perform tailing, thereby completing pulling of the silicon rod.

The silicon rod was cut by using a cutting-off machine to a suitable length, and the silicon rod was machined into a square rod after being flowed to a square cutter. The square rod was ground and polished by using a polisher, and then was flowed to a slicer, and the silicon square rod is sliced and machined into a silicon wafer by using a diamond wire.

A total of 40 silicon wafers were obtained by the method described in Embodiment 1. The minority carrier lifetimes of these silicon wafers were detected by using a WCT-120 instrument (with the corresponding parameters of the silicon wafers input and an injection concentration of 3E15 selected for the test). The minority carrier lifetimes of the 40 silicon wafers were tested, and the average value of the minority carrier lifetimes was calculated. Meanwhile, the doping concentrations of carbon and antimony in the silicon wafers were detected by using an ICP-MS method, and the obtained concentrations were consistent with the concentrations of antimony and carbon in the foregoing Sb-containing dopant.

The silicon wafers were a rectangle. Measured by a micrometer, a length of one side of the rectangle was 200 mm, and a length of the other side of the rectangle was 200 mm. A projection length of an arc length of a chamfer was 5 mm, and a thickness of the silicon wafers was 100 µm. A total oxygen content in the silicon wafers was tested to be less than 18 ppma by using a secondary ion mass spectrometry SIMS method, and the resistivity of the silicon wafers was tested to be 5 Ω·cm by using a four-probe tester.

### Embodiments 2 to 11

Silicon wafers were prepared by adopting the identical method as in Embodiment 1, with only the doping concentrations of antimony and carbon in the dopant used in Embodiment 1 and the ratio of the two doping concentrations adjusted, while all other conditions remained unchanged. The minority carrier lifetime, mechanical strength, and solar cell efficiency of the 40 silicon wafers obtained in the embodiments were tested by using a WCT-120 instrument (with the corresponding parameters of the silicon wafers input and an injection concentration of 3E15 selected for the test), and the average values thereof were calculated.

### Comparative Examples 1 to 2

Silicon wafers were prepared by adopting the identical method as in Embodiment 1, with only the dosage of the dopant used in Embodiment 1 adjusted, while all other conditions remained unchanged. The minority carrier lifetime, mechanical strength, and solar cell efficiency of the 40 silicon wafers obtained in the comparative examples were tested by using a WCT-120 instrument (with the corresponding parameters of the silicon wafers input and an injection concentration of 3E15 selected for the test), and the average values thereof were calculated.

### Performance Test

An N-type TOPcon solar cell was prepared by using the silicon wafers from Embodiments 1 to 11 and Comparative Examples 1 to 2, and the efficiency of the solar cells was measured.

The data of Embodiments 1 to 11 and the data of Comparative Examples 1 to 2 are summarized in Table 1.

**Table 1**

| | Sb doping concentration (cm⁻³) | C doping concentration (cm⁻³) | Sb/C ratio | Average minority carrier lifetime (µs) | Mechanical strength (MPa) | Solar cell efficiency |
|---|---|---|---|---|---|---|
| Embodiment 1 | 4E+14 | 4E+13 | 10:1 | 1450 | 218 | 24.7% |
| Embodiment 2 | 4E+14 | 8E+13 | 5:1 | 1490 | 219 | 24.6% |
| Embodiment 3 | 4E+14 | 4E+14 | 1:1 | 1500 | 220 | 25% |
| Embodiment 4 | 1E+15 | 1E+14 | 10:1 | 1480 | 220 | 25.8% |
| Embodiment 5 | 1E+15 | 5E+14 | 5:1 | 1485 | 221 | 25.6% |
| Embodiment 6 | 1E+15 | 1E+15 | 1:1 | 1490 | 223 | 26% |
| Embodiment 7 | 1E+16 | 1E+15 | 10:1 | 1475 | 225 | 25.6% |
| Embodiment 8 | 1E+16 | 5E+15 | 5:1 | 1478 | 227 | 25.4% |
| Embodiment 9 | 1E+16 | 1E+16 | 1:1 | 1480 | 230 | 25.4% |
| Embodiment 10 | 2E+16 | 2E+15 | 10:1 | 1470 | 228 | 24.2% |
| Embodiment 11 | 2E+16 | 1E+16 | 5:1 | 1472 | 225 | 24% |
| Embodiment 12 | 2E+16 | 2E+16 | 1:1 | 1475 | 220 | 25% |
| Comparative Example 1 | 4E+14 | 1E+16 | 1:25 | 1350 | 202 | 23% |
| Comparative Example 2 | 1E+16 | 5E+14 | 20:1 | 1300 | 200 | 24% |

Although the implementations of the present application are described above, the present application is not limited to the foregoing specific implementations and application fields, and the foregoing specific implementations are merely exemplary and instructive rather than limiting. A person of ordinary skill in the art may further make, under the teaching of this specification, various forms without departing from the protection scope of the claims of the present application, and all the forms fall within the protection scope of the present application.

## Claims

1. A silicon wafer, comprising antimony and carbon, wherein a ratio of a doping concentration of antimony to a doping concentration of carbon ranges from 1:0.1 to 1:12.5.

2. The silicon wafer according to claim 1, wherein the doping concentration of carbon ranges from 4E+13 cm⁻³ to 2.5E+17 cm⁻³,

3. The silicon wafer according to claim 1 or 2, wherein the doping concentration of antimony ranges from 4E+14 cm⁻³, to 2E+16 cm⁻³, preferably from 4.3E+14 cm⁻³, to 1.9E+16 cm⁻³, and further preferably from 4.45E+14 cm⁻³, to 1.87E+16 cm⁻³,

4. The silicon wafer according to any one of claims 1 to 3, wherein when the doping concentration of antimony is greater than or equal to 4E+14 cm⁻³ and less than or equal to a, the ratio of the doping concentration of antimony to the doping concentration of carbon ranges from 1:b to 1:12.5, a being selected from the range of 8E+15 cm⁻³ to 1.2E+16 cm⁻³, preferably from 9E+15 cm⁻³, to 1.1E+16 cm⁻³, and further preferably being 1E+16 cm⁻³, and b being greater than 0.1, preferably greater than 0.5, and further preferably greater than 0.7.

5. The silicon wafer according to any one of claims 1 to 3, wherein when the doping concentration of antimony is greater than or equal to a and less than or equal to 2E+16 cm⁻³, the ratio of the doping concentration of antimony to the doping concentration of carbon ranges from 1:0.1 to 1:c, a being selected from the range of 8E+15 cm⁻³ to 1.2E+16 cm⁻³, preferably from 9E+15 cm⁻³ to 1.1E+16 cm⁻³, and further preferably being 1E+16 cm⁻³, and c being less than 0.8, preferably less than 0.5, and further preferably less than 0.3.

6. The silicon wafer according to any one of claims 1 to 5, wherein the silicon wafer has a resistivity of 0.3 Ω·cm to 10 Ω·cm, preferably 0.4 Ω·cm to 8 Ω·cm, and further preferably 0.5 Ω·cm to 6 Ω·cm.

7. The silicon wafer according to any one of claims 1 to 6, wherein a minority carrier lifetime of the silicon wafer is greater than or equal to 200 microseconds, preferably greater than or equal to 300 microseconds, and further preferably greater than or equal to 500 microseconds.

8. The silicon wafer according to any one of claims 1 to 7, wherein a resistivity variation rate of the silicon wafer is less than or equal to 0.6, preferably less than or equal to 0.5, and more preferably less than or equal to 0.4.

9. The silicon wafer according to any one of claims 1 to 8, wherein a total oxygen content in the silicon wafer is less than 25 ppma, preferably less than 18 ppma, and further preferably less than 14 ppma; or
the total oxygen content in the silicon wafer is greater than 2 ppma, preferably greater than 3 ppma, and further preferably greater than 4 ppma.

10. The silicon wafer according to any one of claims 1 to 9, further comprising at least one of phosphorus, gallium, or germanium.

11. The silicon wafer according to any one of claims 1 to 10, wherein a mechanical strength of the silicon wafer is greater than or equal to 70 MPa, and/or a dispersion degree of the mechanical strength of the silicon wafer is less than or equal to 0.9.

12. The silicon wafer according to any one of claims 1 to 11, wherein a length of at least one side of the silicon wafer is greater than or equal to 156 mm.

13. The silicon wafer according to any one of claims 1 to 12, wherein the silicon wafer is a rectangle, one side of the rectangle having a length of 156 mm to 300 mm, and the other side having a length of 83 mm to 300 mm.

14. The silicon wafer according to any one of claims 1 to 13, further comprising a chamfer connected between two adjacent sides of the silicon wafer, wherein a projection length of an arc length of the chamfer ranges from 1 mm to 10 mm.

15. The silicon wafer according to any one of claims 1 to 14, wherein a thickness of the silicon wafer ranges from 40 µm to 170 µm, preferably 70 µm to 160 µm, and further preferably 80 µm to 140 µm.

16. A solar cell, comprising the silicon wafer according to any one of claims 1 to 15.

17. The solar cell according to claim 16, wherein a mechanical strength of the solar cell is greater than or equal to 50 Mpa, preferably greater than or equal to 60 Mpa, and more preferably greater than or equal to 70 Mpa.

18. The solar cell according to claim 16 or 17, wherein a thickness of the solar cell ranges from 40 µm to 170 µm, preferably 70 µm to 160 µm, and further preferably 80 µm to 140 µm.

19. The solar cell according to any one of claims 16 to 18, wherein one side of the solar cell has a length of 156 mm to 300 mm, and the other side of the solar cell has a length of 83 mm to 300 mm.

20. A solar cell, comprising a silicon substrate, wherein the silicon substrate comprises a silicon matrix and a doped region inside a surface of at least one side of the silicon substrate, the silicon substrate contains antimony and carbon, the doped region is doped with a doping element, the doping element is selected from Group-IIIA elements or Group-VA elements, and a ratio of a doping concentration of antimony to a doping concentration of carbon ranges from 1:0.1 to 1:12.5.

21. The solar cell according to claim 20, wherein the doping concentration of carbon ranges from 4E+13 cm⁻³ to 2.5E+17 cm⁻³.

22. The solar cell according to claim 20 or 21, wherein the doping concentration of antimony ranges from 4E+14 cm⁻³ to 2E+16 cm⁻³, preferably from 4.3E+14 cm⁻³ to 1.9E+16 cm⁻³, and further preferably from 4.45E+14 cm⁻³ to 1.87E+16 cm⁻³.

23. The solar cell according to any one of claims 20 to 22, wherein when the doping concentration of antimony is greater than or equal to 4E+14 cm⁻³ and less than or equal to a, the ratio of the doping concentration of antimony to the doping concentration of carbon ranges from 1:b to 1:12.5, a being selected from the range of 8E+15 cm⁻³ to 1.2E+16 cm⁻³, preferably from 9E+15 cm⁻³ to 1.1E+16 cm⁻³, and further preferably being 1E+16 cm⁻³, and b being greater than 0.1, preferably greater than 0.5, and further preferably greater than 0.7.

24. The solar cell according to any one of claims 20 to 23, wherein when the doping concentration of antimony is greater than or equal to a and less than or equal to 2E+16 cm⁻³, the ratio of the doping concentration of antimony to the doping concentration of carbon ranges from 1:0.1 to 1:c, a being selected from the range of 8E+15 cm⁻³ to 1.2E+16 cm⁻³, preferably from 9E+15 cm⁻³ to 1.1E+16 cm⁻³, and further preferably being 1E+16 cm⁻³, and c being less than 0.8, preferably less than 0.5, and further preferably less than 0.3.

25. The solar cell according to any one of claims 20 to 24, wherein the silicon substrate has a resistivity of 0.3 Ω·cm to 10 Ω·cm, preferably 0.4 Ω·cm to 8 Ω·cm, and further preferably 0.5 Ω·cm to 6 Ω·cm.

26. The solar cell according to any one of claims 20 to 25, wherein a minority carrier lifetime of the silicon substrate is greater than or equal to 200 microseconds, preferably greater than or equal to 300 microseconds, and further preferably greater than or equal to 500 microseconds.

27. The solar cell according to any one of claims 20 to 26, wherein a resistivity variation rate of the silicon substrate is less than or equal to 0.6, preferably less than or equal to 0.5, and more preferably less than or equal to 0.4.

28. The solar cell according to any one of claims 20 to 27, wherein a total oxygen content in the silicon substrate is less than 25 ppma, preferably less than 18 ppma, and further preferably less than 14 ppma; or the total oxygen content in the silicon substrate is greater than 2 ppma, preferably greater than 3 ppma, and further preferably greater than 4 ppma.

29. The solar cell according to any one of claims 20 to 28, wherein the silicon matrix further comprises at least one of phosphorus, gallium, or germanium.

30. The solar cell according to any one of claims 20 to 29, wherein at least one doped layer is provided on a surface of at least one side of the silicon substrate.

31. The solar cell according to claim 30, wherein at least one passivation layer is provided between the doped layer and the doped region.

32. The solar cell according to any one of claims 20 to 31, wherein the doping concentration of antimony in the doped region is substantially constant in a thickness direction of the silicon substrate.

33. The solar cell according to any one of claims 20 to 32, wherein
in the doped region, a sum of the doping concentration of antimony and a doping concentration of the doping element is less than or equal to 1E+21 cm⁻³.

34. The solar cell according to any one of claims 20 to 33, further comprising:
a light absorbing body, the light absorbing body comprising the silicon substrate for absorbing light and generating photogenerated carriers and a region for separating the carriers generated by the silicon substrate; and
an electrode formed on the light absorbing body, the electrode comprising a metallic crystal part in contact with the light absorbing body, and the metallic crystal part comprising antimony.

35. The solar cell according to any one of claims 20 to 34, wherein a mechanical strength of the solar cell is 50 MPa, preferably greater than or equal to 60 Mpa, and more preferably greater than or equal to 70 Mpa.

36. A solar cell string, comprising solar cells connected to each other by using a conductive interconnection member, wherein at least one of the solar cells is the solar cell according to any one of claims 16 to 35.

37. The solar cell string according to claim 36, wherein a curvature of the solar cell is less than or equal to 2 mm.

38. The solar cell string according to claim 36 or 37, wherein the connection wire is bonded to the solar cell by soldering or conductive adhesion.

39. The solar cell string according to claim 38, wherein the soldering comprises a heating step.

40. The solar cell string according to claim 39, wherein a temperature interval of the heating step ranges from 100 to 160 degrees Celsius, and the curvature of the solar cell is less than or equal to 1.5 mm.

41. The solar cell string according to claim 39, wherein a temperature interval of the heating step ranges from 165 to 200 degrees Celsius, and the curvature of the solar cell is less than or equal to 2 mm.

42. The solar cell string according to any one of claims 36 to 41, wherein the conductive interconnection member comprises an electric contact part in contact with an electrode of the solar cell, and the electric contact part comprises antimony.

43. A solar module, comprising a plurality of solar cells, an encapsulation layer, a cover, and a back sheet, wherein the plurality of solar cells are encapsulated in the encapsulation layer, the encapsulation layer is located between the cover and the back sheet, and the solar cell is the solar cell according to any one of claims 16 to 35.

44. The solar module according to claim 43, wherein a curvature of the solar cell is less than or equal to 1.2 mm.

45. The solar module according to claim 43 or 44, further comprising a frame, wherein an edge of the cover and/or the back sheet is embedded in a mounting part of the frame.

46. The solar module according to any one of claims 43 to 45, wherein the cover and/or the back sheet is transparent.

47. The solar module according to any one of claims 43 to 45, wherein the cover and/or the back sheet is non-transparent.

48. The solar module according to any one of claims 43 to 47, wherein the solar cell protrudes toward the cover to form a curved shape.

49. The solar module according to any one of claims 43 to 48, wherein the plurality of solar cells are connected to each other by using a conductive interconnection member, the conductive interconnection member comprises an electric contact part in contact with an electrode of the solar cell, and the electric contact part comprises antimony.
